# EUROPÄISCHE PATENTSCHRIFT

(11) **EP 2 954 558 B1**
(45) Veröffentlichungstag und Bekanntmachung des Hinweises auf die Patenterteilung: **07.11.2018**
(21) Anmeldenummer: 14703858.2
(22) Anmeldetag: 11.02.2014
(51) Int. Cl.: G01R 31/02, H02S 50/00

(54) **SICHERE PHOTOVOLTAIK-ANLAGE**
SAFE PHOTOVOLTAIC SYSTEM
INSTALLATION PHOTOVOLTAÏQUE

(30) Priorität: 11.02.2013 DE 102013101314
(43) Veröffentlichungstag der Anmeldung: 16.12.2015
(73) Patentinhaber: Phoenix Contact GmbH & Co. KG, 32825 Blomberg (DE)
(72) Erfinder: HÖFT, Wolfgang, 32683 Barntrup (DE); JANKOWSKI, Martin, 30926 Seelze (DE)
(74) Vertreter: Blumbach · Zinngrebe Patent- und Rechtsanwälte
(86) Internationale Anmeldenummer: PCT/EP2014/052663
(87) Internationale Veröffentlichungsnummer: WO 2014/122325

(56) Entgegenhaltungen:
- WO-A2-2010/078303
- WO-A2-2011/023732
- DE-A1-102010 054 354
- DE-A1-102011 079 074
- DE-A1-102011 107 365
- US-A1- 2011 172 842

## Beschreibung

### Gebiet der Erfindung

Die Erfindung betrifft eine Photovoltaik-Anlage mit zu zumindest einem seriellen Strang zusammengeschalteten Solarmodulen und einem System zum einzelnen Freischalten der Solarmodule und zum sicheren Wiederanschalten der freigeschalteten Solarmodule an den Strang.

### Hintergrund der Erfindung

Bisher sind Solarmodule häufig ohne besondere Sicherheitsvorkehrungen ausgestattet. Die bei jedem Solarmodul vorhandene Solaranschlussdose (auch Anschlussbox oder junction box genannt) dient im Wesentlichen zur Aufnahme der mechanischen Anschlüsse der Leiterbänder (auch ribbons genannt) des Solarmoduls sowie deren Bypass-Dioden. Solch einfache Solarmodule liefern Spannung sobald sie beleuchtet werden.

Typischerweise werden die Solarmodule zu so genannten Strängen (auch strings genannt) seriell zusammengeschaltet, um eine hohe Strangspannung zu erreichen. Diese Spannung der zu Strängen verschalteten Solarmodule kann mehrere 100 V betragen, wobei für Großanlagen sogar Arbeitsspannungen von im Bereich von 1000 V oder sogar mehr vorliegen, was eine berührgefährliche Spannung darstellt. Ein Solarkraftwerk umfasst ferner ggf. mehrere parallel geschaltete Stränge.

Während der Montage der Solarmodule und deren elektrischer Verbindung in dem Strang kann es bei entsprechender Beleuchtung demnach zu sehr hohen Spannungen kommen, die einen vorsichtigen Umgang bzw. einen besonderen Berührschutz notwendig machen. Gleiches gilt für die Wartung.

Bei solch einfachen Photovoltaik-Anlagen befindet sich die erste Möglichkeit die Solargeneratorspannung vom Netz zu trennen am Generatoranschlusskasten. Daher besteht bei Schäden durch Feuer, Wasser, Hagel oder anderen Störungen an den Solarmodulen oder den Strangleitungen bei diesen einfachen Solarmodulen keine Möglichkeit den Teil der Photovoltaik-Anlage mit den Solarmodulen und den Strangleitungen spannungsfrei zu schalten.

Es sind Sicherheitseinrichtungen bekannt, welche die einzelnen Solarmodule im Brand- oder Fehlerfall abschalten (z.B. DE 10 2009 024 516 A1). Solche Lösungen sind jedoch zumeist lediglich auf eine einmalige Notfallabschaltung ausgerichtet.

In der DE 10 2011 110 682 (nicht vorveröffentlicht) ist eine Anschlussdose beschrieben, welche bei Abweichung der zulässigen Parameter vom Betriebszustand in einen Sicherheitszustand umschaltet.

In Weiterentwicklung der in der DE 10 2011 110 682 beschriebenen Erfindung betrifft die vorliegende Erfindung insbesondere das kontrollierte und sichere erstmalige Einschalten einer Photovoltaik-Anlage mit "intelligenten" Solaranschlussdosen bzw. das sichere und kontrollierte Wiedereinschalten nach einer Abschaltung der Solaranschlussdosen, zum Beispiel nach Störfällen, Wartung oder bei Sonnenaufgang. Der Inhalt der DE 10 2011 110 682 wird hiermit durch Referenz inkorporiert.

In der WO 2010/078303 ist ein Signalgenerator beschrieben, welcher kontinuierlich ein HF-Freigabesignal an den Plus- oder Minus-Ast eines PV-Strangs anlegt. Nachteilig hierbei ist, dass das HF-Freigabesignal dauerhaft anliegen muss, um die Anlage im Betriebszustand zu halten und die PV-Module ggf. keine elektrische Leistung für Bauteile in der Junction Box bereitstellen oder zusätzliche HF-Signalbeipässe erfordern und keine sichere Verhinderung von Offenspannungen gewährleisten. Ferner kann durch den Freigabesignal-Generator Leistungsverlust bzw. zusätzlicher Energieverbrauch entstehen. Bei einer Störung des HF-Freigabesignals können PV-Module oder sogar der gesamte PV-Strang unnötigerweise abschalten, was zu reduzierter Einspeisung führen kann.

### Allgemeine Beschreibung der Erfindung

Es ist daher eine Aufgabe der vorliegenden Erfindung, eine Photovoltaik-Anlage bereit zu stellen, welche hohen Sicherheitsanforderungen genügt, insbesondere welche ein sicheres und kontrolliertes erstmaliges Einschalten nach der Montage oder Wiedereinschalten zum Beispiel nach Störfällen, Wartung oder Sonnenaufgang ermöglicht.

Ein weiterer Aspekt der Aufgabe ist, sicherzustellen, dass der Stromkreis des Strangs geschlossen ist, wenn die Solarmodule photovoltaisch erzeugte Spannung an den Strang anlegen, damit keine so genannte Offenspannung bei nicht geschlossenem Stromkreis an möglicherweise offenen Kontakten anliegen kann, und dass die Effizienz der Photovoltaik-Anlage optimiert wird bzw. möglichst wenig Leistungsverlust erzeugt wird.

Weitere Aufgaben ergeben sich aus der nachfolgenden Beschreibung bzw. den besonderen Vorteilen die mit bestimmten Ausführungsformen erzielt werden.

Die Aufgabe wird durch den Gegenstand der unabhängigen Ansprüche gelöst. Vorteilhafte Ausführungsformen sind Gegenstand der abhängigen Ansprüche.

Die Photovoltaik-Anlage umfasst zumindest einen Strang aus seriell zusammengeschalteten Solarmodulen und ein System zum einzelnen Freischalten der Solarmodule und zum sicheren erstmaligen Anschalten oder Wiederanschalten der freigeschalteten Solarmodule an den Strang. Selbstverständlich können auch mehrere Stränge vorhanden und parallel geschaltet sein. Die Solarmodule umfassen jeweils eine Solaranschlussdose (auch (Solar-)Anschlussbox oder junction box genannt), welche an dem zugehörigen Solarmodul, typischerweise auf der Rückseite des zugehörigen Solarmoduls, befestigt, z.B. aufgeklebt ist und eingangsseitige Plus- und Minus-Anschlusselemente umfasst, typischerweise in Form von Kontaktklemmen, mit welchen die aus der Oberfläche des Solarmoduls heraustretenden spannungsführenden Leiterbänder (auch ribbons genannt) des Pluspols bzw. Minuspols des zugehörigen Solarmoduls in der Solaranschlussdose angeschlossen bzw. kontaktiert sind. Die Solaranschlussdosen dienen als Verbinder zwischen den Strangleitungen und den spannungsführenden Leiterbändern des zugehörigen Solarmoduls. Die Solaranschlussdosen weisen daher ferner ausgangsseitige Plus- und Minus-Anschlusselemente auf, die im Inneren der Solaranschlussdose mit dem jeweiligen eingangsseitigen Anschlusselement elektrisch verbunden sind. Die Strangleitung besteht aus Verbindungskabeln, welche die Solarmodule des Strangs seriell miteinander verbinden und sind hierzu an die Plus- und Minus-Anschlusselemente der Solaranschlussdosen angeschlossen. Je nach Ausführung werden die Verbindungskabel innerhalb der Solaranschlussdosen kontaktiert oder die ausgangsseitigen Plus- und Minus-Anschlusselemente sind als Steckverbinder ausgebildet und die Verbindungskabel weisen hierzu paarbare Steckverbinder auf, so dass die Verbindungskabel vor Ort an die Solaranschlussdosen angesteckt werden können. Demnach sind die Solarmodule seriell mittels der an die ausgangsseitigen Plus- und Minus-Anschlusselemente angeschlossenen Strangleitung zu dem Strang verbunden. Die Strangleitung bildet hierbei einen Stromkreis aus den seriell zusammengeschalteten Solarmodulen und einem Wechselrichter.

Erfindungsgemäß weist zumindest eine der Solaranschlussdosen eine Sicherheitsschaltung auf. Die Sicherheitsschaltung definiert einen Betriebszustand des Solarmoduls mit der zugehörigen Solaranschlussdose, in welchem der von dem zugehörigen Solarmodul erzeugte Solarstrom durch die Solaranschlussdose über die ausgangsseitigen Anschlusselemente und die Strangleitung an den Wechselrichter und damit an das Stromnetz abgeführt wird und einen Sicherheitszustand des Solarmoduls mit der zugehörigen Solaranschlussdose, in welchem das zugehörige Solarmodul in Bezug auf die angeschlossene Strangleitung mittels der Sicherheitsschaltung (spannungs-)freigeschaltet ist. Eine Solaranschlussdose mit einer solchen Sicherheitsschaltung wird im Folgenden auch als "intelligente Solaranschlussdose" bezeichnet. Idealerweise weisen alle oder zumindest fast alle Solarmodule solche intelligenten Solaranschlussdosen auf, damit alle oder fast alle Solarmodule des Strangs einzeln freigeschaltet werden können, was die Sicherheit beim ersten Aufbauen der Photovoltaik-Anlage, beim Warten, beim Reparieren oder einem Störfall wie einem Brand gewährleistet, da allenfalls nur noch wenige bis keine der Solarmodule in einem solchen Fall Spannung an die Strangleitung anlegen. Es kann sogar vorgesehen sein, dass die intelligenten Solaranschlussdosen Solarmodule bei Abschattung oder nachts freischalten.

Nun müssen die Solarmodule nach einer derartigen Freischaltung aber auch wieder eingeschaltet bzw. an den Strang angeschaltet werden. Hierzu ist gemäß der vorliegenden Erfindung eine an die Strangleitung angeschlossene Starterschaltung umfasst, welche dazu ausgebildet ist, einen Startstrom in die Strangleitung einzuprägen. Die intelligenten Solaranschlussdosen schließen in dem Sicherheitszustand trotz freigeschalteter Solarmodule den Stromkreis des Strangs, vorzugsweise durch Kurzschlussschalter die im Sicherheitszustand die ausgangsseitigen Plus- und Minus-Anschlusselemente kurzschließen.

Ferner sind die Sicherheitsschaltungen der intelligenten Solaranschlussdosen erfindungsgemäß dazu ausgebildet, in Ansprechen auf den in die Strangleitung eingeprägten Startstrom vom Sicherheitszustand in den Betriebszustand umzuschalten, d.h. vorzugsweise den Kurzschlussschalter in der jeweiligen intelligenten Solaranschlussdose zu öffnen und/oder das Solarmodul wieder an die Strangleitung anzuschalten, und damit den Strang bzw. die Photovoltaik-Anlage zu starten. Der eingeprägte Startstrom fließt bzw. läuft dabei im Sicherheitszustand durch die serielle Strangleitung und die Solaranschlussdosen, so das sichergestellt ist, dass die Strangleitung geschlossenen ist und nach dem Anschalten keine berührgefährliche Offenspannung entstehen kann.

Der Startstrom ist in einem einfachen Beispiel ein Konstantstrom, welcher von der Sicherheitsschaltung der intelligenten Solaranschlussdosen gemessen wird und in Ansprechen hierauf, die Sicherheitsschaltung vom Sicherheitszustand in den Betriebzustand umschaltet. Der Startstrom kann allerdings auch gepulst sein, also in Form eines oder mehrerer Strompulse ausgebildet sein. Durch Stromhöhe und/oder Pulsform können sogar weitere Informationen an die intelligenten Solaranschlussdosen übermittelt werden, die das Betriebsverhalten der Sicherheitsschaltung beeinflussen. Der Startstrom kann auch höher kodierte Information enthalten, z.B. in einem durch Strompulse kodierten Signal oder es kann eine höhere Kommunikation, z.B. Powerline über den Strang stattfinden, indem entsprechende Startsignale auf die Strangleitung aufmoduliert und damit eingeprägt werden. Zum Anschalten ist dennoch sichergestellt, dass der Startstrom nur dann durch die Strangleitung fließen kann, wenn diese nicht unterbrochen ist, damit keine berührgefährliche Offenspannung nach dem Anschalten entstehen kann

In vorteilhafter Weise stellt die Erfindung somit nicht nur die Möglichkeit einer Einzelabschaltung der Solarmodule vom Strang bereit, sondern auch eine Möglichkeit zum sicheren erstmaligen Anschalten oder Wiederanschalten der einzeln abgeschalteten Solarmodule mit den "intelligenten" Solaranschlussdosen. Weitere Sicherheits- oder Funktionsrelevante Parameter, z.B. Modulspannung, Strangspannung und/oder Modultemperatur können zusätzlich in den intelligenten Solaranschlussdosen überwacht werden und das Umschalten der Sicherheitsschaltung zwischen dem Sicherheitszustand und dem Betriebszustand in Ansprechen hierauf gesteuert werden.

Gemäß einer Ausführungsform ist die Starterschaltung in einer separat an die Strangleitung angeschlossenen Startbox untergebracht und ist insbesondere seriell zu den Solarmodulen an die Strangleitung geschaltet. Die Startbox wird vorzugsweise in der Nähe des Wechselrichters bzw. bei einer Hausanlage im Gebäudeinneren, zugänglich für den Nutzer angeordnet, so dass hiermit die Umschaltvorgänge der intelligenten Solaranschlussdosen bequem initialisiert werden können. Auch erleichtert dies Wartung und Austausch der Starterbox.

Gemäß einer einfachen Ausführungsform umfasst die Starterschaltung einen in Bezug auf die Strangleitung seriellen Schalter, welcher geschlossen wird, um den Stromkreis der Strangleitung unter Einschluss der Starterschaltung zu schließen und das Fließen des Startstroms oder Laufen des Startsignals in dem so geschlossenen Stromkreis der Strangleitung und den Solarmodulen zu bewirken. Der hierdurch geschlossene Stromkreis aus Strangleitung mit Solarmodulen und Starterschaltung ist vorzugsweise parallel zum Wechselrichter, d.h. unter Umgehung des Wechselrichters geschlossen. Mit anderen Worten bildet die Starterschaltung in dem Strang vorzugsweise einen Bypass zum Wechselrichter bzw. die Starterschaltung ist seriell zu den Solarmodulen und im Nebenschluss zu dem Wechselrichter an die Strangleitung geschaltet.

Die Sicherheitsschaltung in den intelligenten Solaranschlussdosen umfasst einen parallel zu dem zugehörigen Solarmodul geschalteten Kurzschlussschalter zwischen den ausgangsseitigen Plus- und Minus-Anschlusselementen und einen seriell in den Strang geschalteten Freischalter. Dabei ist der Kurzschlussschalter in dem Sicherheitszustand geschlossen und schließt die ausgangsseitigen Plus- und Minus-Anschlusselemente der Solaranschlussdose miteinander kurz. Der Freischalter ist in dem Sicherheitszustand geöffnet und trennt den Kurzschlussschalter zumindest einseitig von dem Solarmodul. In dem Betriebszustand ist der Kurzschlussschalter geöffnet und der Freischalter geschlossen und ermöglicht so das verlustfreie Abführen der photovoltaisch erzeugten Leistung des Solarmoduls. Im Betriebszustand ist die Strangleitung über die Solarmodule geschlossen. Der Kurzschlussschalter hingegen gewährleistet, dass die Strangleitung im Sicherheitszustand geschlossen ist, obwohl die Solarmodule von der Strangleitung freigeschaltet sind. Die Trennung des Solarmoduls von dem Kurzschlussschalter im Sicherheitszustand gewährleistet ferner, dass die Sicherheitsschaltung auch in dem Sicherheitszustand von dem zugehörigen Solarmodul mit elektrischer Leistung versorgt wird, sofern genug Licht eingestrahlt wird.

Vorzugsweise weist die Solaranschlussdose eine zentrale Bypassschaltung, insbesondere eine zentrale Bypassdiode auf, welche parallel zu dem Kurzschlussschalter geschaltet ist. Die zentrale Bypassschaltung verhindert wie üblich zusätzlich eine Beschädigung des zugehörigen Solarmoduls bei Abschattung.

Insbesondere umfasst die Sicherheitsschaltung eine elektronische Steuereinrichtung, z.B. in Form eines Mikrocontrollers, welcher in der jeweiligen Solaranschlussdose untergebracht ist und in Ansprechen auf den in die Strangleitung eingeprägten Startstrom oder das Startsignal die Umschaltung zwischen dem Sicherheitszustand und dem Betriebszustand der Sicherheitsschaltung steuert, d.h. insbesondere den Freischalter und/oder den Kurzschlussschalter steuert, also den Kurzschlussschalter öffnet und/oder den Freischalter schließt, wenn die intelligente Solaranschlussdose vom Sicherheitszustand in den Betriebszustand schaltet. Der Mikrocontroller wird hierfür nicht nur im Betriebszustand, sondern auch im Sicherheitszustand von dem zugehörigen Solarmodul mit elektrischer Leistung versorgt, um die Schaltvorgänge steuern zu können.

Die Sicherheitsschaltung weist einen Stromsensor auf, welcher den in die Strangleitung eingeprägten Startstrom misst (im einfachsten Fall detektiert). Die Steuereinrichtung liest den Stromsensor aus, um in Ansprechen auf das Messergebnis die Sicherheitsschaltung von dem Sicherheitszustand automatisch in den Betriebszustand umzuschalten, wobei insbesondere auch hierfür die elektrische Leistung zum Betreiben der Steuereinrichtung von dem zugehörigen freigeschalteten Solarmodul geliefert wird.

Wenn der Strang der Photovoltaik-Anlage eingeschaltet werden soll, d.h. die Sicherheitsschaltungen der Solarmodule aus dem Sicherheitszustand in den Betriebszustand versetzt werden sollen, wird der Startstrom in die Strangleitung eingeprägt und von dem Stromsensor der jeweiligen Sicherheitsschaltung an den Solarmodulen gemessen oder detektiert. Der Startstrom fließt im Sicherheitszustand über die Kurzschlussschalter der Sicherheitsschaltungen. Der Startstrom kann aber nur dann durch die Strangleitung fließen, wenn die Strangleitung geschlossen ist. Mit anderen Worten kann der Startstrom nicht durch die Strangleitung fließen, wenn die Strangleitung z.B. durch einen Störfall unterbrochen oder sonst wie offen ist. Somit wird durch die Messung oder Detektion des durch den Stromkreis der geschlossenen Strangleitung fließenden Startstromes und das in Abhängigkeit von dem zugehörigen Mess- oder Detektionsergebnis bewirkte automatische Anschalten erreicht, dass alle Sicherheitsschaltungen in dem Strang nur dann automatisch anschalten können, wenn der Stromkreis der Strangleitung geschlossen und nicht offen, insbesondere nicht unterbrochen ist.

Vorzugsweise ist die Sicherheitsschaltung in den intelligenten Solaranschlussdosen derart ausgebildet, dass sie bei Abschattung des zugehörigen Solarmoduls oder bei allgemeiner Dunkelheit und dem damit verbundenen Abfall der Modulspannung unter einen vordefinierten Schwellenwert automatisch von dem Betriebszustand in den Sicherheitszustand schaltet. Bevorzugt ist der Kurzschlussschalter hierzu als Öffner ausgebildet und im Ruhezustand geschlossen und/oder der Freischalter ist als Schließer ausgebildet ist und im Ruhezustand geöffnet. Damit wird vorteilhafterweise sichergestellt, dass die Sicherheitsschaltung automatisch in den Sicherheitszustand schaltet, wenn z.B. bei eintretender Dunkelheit die von dem zugehörigen Solarmodul gelieferte Leitung nicht mehr zur Versorgung der Steuereinrichtung ausreicht. Mit anderen Worten befinden sich in dem Sicherheitszustand der Kurzschlussschalter und der Freischalter im Ruhezustand und müssen aus dem jeweiligen Ruhezustand mittels der Steuereinrichtung aktiviert werden, um in Ansprechen auf die Aktivierung die Sicherheitsschaltung vom Ruhe-Sicherheitszustand in den Betriebszustand umzuschalten. Demnach ist der Sicherheitszustand der Ruhezustand der Sicherheitsschaltung und für das Umschalten vom Ruhe-Sicherheitszustand in den Betriebszustand ist ein aktiver Einschaltvorgang notwendig. Dies erhöht die Sicherheit der Photovoltaik-Anlage.

Ferner bevorzugt weist die Solaranschlussdose zumindest eine der folgenden Einrichtungen auf:
- einen ersten Spannungssensor, welcher die Modulspannung des zugehörigen Solarmoduls misst,
- einen zweiten Spannungssensor, welcher die Strangspannung misst,
- einen Temperatursensor welcher die Temperatur des zugehörigen Solarmoduls überwacht,
wobei die Steuereinrichtung den ersten Spannungssensor und/oder den zweiten Spannungssensor und/oder den Temperatursensor ausliest und in Ansprechen hierauf die Sicherheitsschaltung steuert. Insbesondere schaltet die Sicherheitsschaltung automatisch in den Sicherheitsmodus um, wenn einer oder mehrere dieser Werte außerhalb vorgegebener Intervallgrenzen liegen. Z.B. stellt der Wechselrichter im Normalbetrieb Strom und Spannung auf den Punkt maximaler Leistung (auch "Maximum Power Point" oder "MPP" genannt). Wenn z.B. die von dem Stromsensor und dem ersten und/oder zweiten Spannungssensor gemessenen Werte hiervon abweichen, schaltet die Sicherheitsschaltung automatisch in den Sicherheitszustand. Demnach erfüllt der Stromsensor eine Doppelfunktion, er misst oder detektiert im Sicherheitszustand den eingeprägten Startstrom oder das Startsignal und misst im Betriebszustand den in den Strang eingespeisten Solarstrom.

Gemäß einer Ausführungsform weisen alle Solarmodule eines Strangs eine wie vorstehend definierte intelligente Solaranschlussdose mit der Sicherheitsschaltung auf. Insbesondere bei dieser Ausführungsform umfasst die Starterschaltung bzw. die Startbox eine eigene Stromquelle zur Erzeugung des Startstroms.

Vorzugsweise ist der Kurzschlussschalter in der Solaranschlussdose von dem Plus- und Minuspol des Solarmoduls aus gesehen vor den ausgangsseitigen Plus- und Minus-Anschlusselementen angeordnet und der Freischalter in der Solaranschlussdose ist seriell zwischen das eingangsseitige Anschlusselement des spannungsführenden Leiters des Pluspols des Solarmoduls und das ausgangsseitige Plus-Anschlusselement oder seriell zwischen das eingangsseitige Anschlusselement des spannungsführenden Leiters des Minuspols des Solarmoduls und das ausgangsseitige Minus-Anschlusselement (bzw. den zugehörigen Anschluss des Kurzschlussschalters) geschaltet.

Der Freischalter ist vorzugsweise seriell zu der zentralen Bypassschaltung und/oder der Kurzschlussschalter ist parallel zu der zentralen Bypassschaltung geschaltet.

Vorzugsweise weist die Solaranschlussdose eingangsseitige Zwischenanschlusselemente für Zwischenabgriffe an dem Solarmodul und mehrere Teilmodul-Bypassschaltungen, insbesondere -dioden zur Kompensation von Teilabschattungen des zugehörigen Solarmoduls auf und die Teilmodul-Bypassschaltungen sind von den Polen des Solarmoduls aus gesehen vor den Freischalter und den Kurzschlussschalter geschaltet, so dass die Teilmodul-Bypassschaltungen auch in dem Sicherheitszustand mit dem Solarmodul verbunden bleiben.

Bevorzugt weist die Starterschaltung eine eigene von den Solarmodulen unabhängige Stromquelle auf und der in die Strangleitung eingeprägte Startstrom oder das Startsignal wird von dieser eigenen Stromquelle gespeist. Die Stromquelle ist z.B. in Form eines Netzteils ausgebildet, und/oder kann in der Startbox integriert sein oder extern an die Startbox angeschlossen werden. Ggf. kann die Stromquelle der Starterschaltung als Energiespeichereinrichtung ausgebildet sein, welche im Normalbetrieb photovoltaisch von dem Strang erzeugte Energie speichert und im Startmodus mit dieser gespeicherten Energie den Startstrom oder das Startsignal speist.

Vorzugsweise weist die Starterschaltung zumindest einen ersten Schalter auf, mittels welchem zum Starten des Strangs ein Stromkreis im Nebenschluss zu dem Wechselrichter in dem Strang geschlossen wird, um das Fließen des Startstroms oder Laufen des Startsignals in dem so geschlossenen Stromkreis der Strangleitung zu bewirken und somit die Sicherheitsschaltungen der Solaranschlussdosen des Strangs vom Sicherheitszustand in den Betriebszustand umzuschalten, d.h. den Strang zu starten.

Ferner vorzugsweise weist die Starterschaltung zumindest einen Freischalter auf, mittels welchem der Wechselrichter zum Starten des Strangs vom Strang freigeschaltet wird.

Zum Einprägen des Startstroms oder Startsignals in die Strangleitung, d.h. zum Starten des Strangs (Startmodus) ist der Freischalter geöffnet und der erste Schalter ist geschlossen, damit der Stromkreis der Strangleitung geschlossen ist. Im Startmodus bildet die Starterschaltung demnach einen Nebenschluss zum (freigeschalteten) Wechselrichter, wobei die Stromquelle für den Startstrom bzw. das Startsignal mit den Solarmodulen einen geschlossenen Stromkreis bilden, um den Startstrom bzw. das Startsignal über diesen Stromkreis in die Strangleitung einzuprägen und damit durch die Solaranschlussdosen durchzuleiten. Daher wird der erste Schalter hier auch als Nebenschlussschalter bezeichnet.

Der Freischalter ist seriell zum Wechselrichter geschaltet, um diesen im Startmodus der Starterschaltung vom Strang freizuschalten. Bei der Ausführungsform der Starterschaltung mit eigener Stromquelle sind der erste Schalter vorzugsweise seriell zur eigenen Stromquelle und/oder der Freischalter parallel zur eigenen Stromquelle geschaltet.

Im Normalbetrieb der Photovoltaik-Anlage, in welchem sich die Sicherheitsschaltungen der Solaranschlussdosen im Betriebszustand befinden, ist der Freischalter der Starterschaltung geschlossen und der erste Schalter oder Nebenschlussschalter der Starterschaltung ist geöffnet, damit die Einspeisung der erzeugten Solarleistung nicht beeinträchtigt wird. Mit anderen Worten ist im Normalbetrieb der Photovoltaikanlage der von der Starterschaltung gebildete Nebenschluss zum Wechselrichter geöffnet. Hierdurch wird unnötiger Leistungsverlust bzw. Energieverbrauch vermieden. Der Betriebszustand ist eigenstabil, in dem Sinne dass es keines kontinuierlichen Freigabesignals durch die Starterschaltung bedarf, um den Strang bzw. die PV-Anlage im Betriebszustand zu halten. Im Betriebszustand ist die Starterschaltung auf Durchlass geschaltet und braucht kein kontinuierliches Freigabesignal in den Strang einzuspeisen. Der Strang ist demnach bistabil ausgelegt, indem der Betriebszustand und der Sicherheitszustand jeweils eigenstabil in Bezug auf die Starterschaltung sind, d.h. die Starterschaltung bewirkt zwar die Umschaltung vom Sicherheitszustand in den Betriebszustand, die Starterschaltung wird aber nicht aktiv benötigt, um den Betriebszustand aufrechtzuerhalten. Dadurch ist das System wenig störungsanfällig und unnötige Abschaltungen in den Sicherheitszustand können ggf. vermieden werden.

Ferner vorzugsweise umfasst die Starterschaltung einen elektronischen Controller, z.B. Mikrocontroller mit einer elektronischen Schnittstelle (Interface) und/oder einem externen Aktivierungsschalter und der Controller steuert in Ansprechen auf ein Aktivierungssignal an der elektronischen Schnittstelle und/oder in Ansprechen auf die Betätigung des Aktivierungsschalters das Einprägen des Startstroms oder Startsignals in die Strangleitung.

Es ist ferner vorteilhaft, wenn der Controller zumindest einen Signalausgang aufweist, welcher den Sicherheitszustand und/oder einen Fehlerzustand signalisiert, z.B. über eine Leuchtdiode anzeigt. Der Controller kann allerdings auch eine elektronische Schnittstelle aufweisen, welche den Sicherheitszustand und/oder einen Fehlerzustand z.B. an einen zentralen Rechner übermittelt.

Vorzugsweise ist in die Solaranschlussdose zumindest eine Diebstahlschutzeinrichtung, eine Maximum-Powerpoint-Tracking-Steuerungseinrichtung, eine Spannungsüberwachungseinrichtung, eine Stromüberwachungseinrichtung und/oder eine Temperaturüberwachungseinrichtung eingebaut, welche von den Polen des Solarmoduls aus gesehen vor den Freischalter und den Kurzschlussschalter geschaltet sind und die Diebstahlschutzeinrichtung, die Maximum-Powerpoint-Tracking-Steuerungseinrichtung, die Spannungsüberwachungseinrichtung, die Stromüberwachungseinrichtung bzw. die Temperaturüberwachungseinrichtung werden auch in dem Sicherheitszustand von dem zugehörigen Solarmodul mit elektrischer Energie versorgt.

Vorzugsweise umfasst die Starterschaltung zumindest eines der folgenden Bauteile:
- einen Stromsensor zum Messen des Strangstroms und/oder
- einen Spannungssensor zum Messen der Strangspannung und/oder
- eine Einrichtung zum Messen der Strangleistung und/oder
- eine Einrichtung zur Erkennung von Lichtbögen in dem Strang und/oder
- eine Einrichtung zur Diebstahlerkennung in dem Strang und/oder
- eine Schnittstelle zur Ausgabe der entsprechenden Werte oder einer entsprechenden Signalisierung.
Diese Informationen können ebenfalls über das Interface des Controllers z.B. an einen zentralen Computer übermittelt werden.

Eine weitere Ausführungsform sieht vor, dass zumindest ein Solarmodul eines Strangs eine Solaranschlussdose ohne die besagte Sicherheitsschaltung aufweist, also diese Solaranschlussdose nicht im vorstehenden Sinne "intelligent" ist, so dass dieses Solarmodul mit nicht-intelligenter Solaranschlussdose nicht in einen Sicherheitszustand versetzt wird, sondern dauerhaft an den Strang angeschaltet bleibt. Hierbei kann die von diesem Solarmodul mit nicht-intelligenter Solaranschlussdose eingespeiste Solarspannung zum Einprägen des Startstroms oder Startsignals in die Strangleitung genutzt werden, um das Umschalten der Sicherheitsschaltungen der anderen Solarmodule vom Sicherheitszustand in den Betriebszustand zu bewirken. Es kann also ggf. auf das Netzteil der Starterschaltung verzichtet werden. In diesem Fall liefert nämlich z.B. bei Sonnenaufgang das nicht-intelligente Solarmodul Solarstrom in die Strangleitung, wobei die intelligenten Solarmodule noch freigeschaltet sind. Mit diesem Solarstrom können dann die intelligenten freigeschalteten Solarmodule getriggert werden, um vom Sicherheitszustand in den Betriebszustand umzuschalten.

Gegenstand der Erfindung ist ferner die Startbox mit der Starterschaltung, welche zum Anschließen an die Strangleitung einer Photovoltaik-Anlage und zum Einprägen des Startstroms oder Startsignals in die Strangleitung ausgebildet ist, um das Umschalten der Sicherheitsschaltung vom Sicherheitszustand in den Betriebszustand zu bewirken, sowie die erfindungsgemäße intelligente Solaranschlussdose bzw. das Solarmodul mit dieser intelligenten Solaranschlussdose.

Ein weiterer Aspekt der Erfindung ist das Verfahren zum sicheren Einschalten des Strangs der seriell geschalteten Solarmodule.

Im Sicherheitszustand schalten die Sicherheitsschaltungen die Solarmodule in Bezug auf die Strangleitung einzeln spannungsfrei. In Ansprechen auf das Einprägen des Startstroms oder Startsignals in die Strangleitung schaltet jede der Sicherheitsschaltungen das jeweils zugehörige Solarmodul an den Strang an, so dass dann die erzeugte Solarleistung über den Strang abgeführt werden kann.

Das Einprägen des Startstroms oder Startsignals wird von einer an den Strang angeschalteten zentralen Startbox gesteuert und zwar in Ansprechen auf:
- Manuelles Betätigen eines Aktivierungsschalters an der Startbox, z.B. durch den Installateur nach der Erstmontage oder nach einer Wartung und/oder
- ferngesteuertes Starten der Starterschaltung durch Senden eines Startsignals an die elektronische Schnittstelle (Interface) des Controllers der Starterschaltung z.B. durch den Installateur nach der Erstmontage oder nach einer Wartung und/oder
- automatisches Starten in Ansprechen auf eine Zeitsteuerung und/oder
- automatisches Starten in Ansprechen auf die Auswertung eines an die Starterschaltung angeschlossenen Einstrahlungssensors, z.B. allmorgendlich nach Sonnenaufgang, wenn die Lichteinstrahlung für die Einspeisung von photovoltaisch erzeugter Leistung der Photovoltaik-Anlage an das Stromnetz ausreicht.

Wie vorstehend bereits beschrieben wird der in die Strangleitung eingeprägte Startstrom oder das Startsignal gespeist:
- von einer eigenen Stromquelle an der Starterschaltung, z.B. ein internes oder externes Netzteil oder eine Energiespeichereinrichtung und/oder
- einem Solarmodul des Strangs mit einer Solaranschlussdose, z.B. ohne die besagte Sicherheitsschaltung, also einem nicht-intelligenten Solarmodul.

Zum Einprägen des Startstroms oder Startsignals in die Strangleitung, um das Umschalten der Sicherheitsschaltungen in den Solaranschlussdosen vom Sicherheitszustand in den Betriebszustand zu bewirken, werden zumindest einige der folgenden Schritte in der Starterschaltung durchgeführt:
- Schließen des Nebenschlussschalters in der Startbox zum Schließen des Stromkreises des Strangs mit den Solarmodulen und Einprägen des Startstroms oder Startsignals in die Strangleitung und durch die intelligenten Solaranschlussdosen,
- Messen der Strangspannung in der Startbox,
- Trennen der Stromquelle zum Einprägen des Startstroms oder Startsignals vom Strang, insbesondere durch Öffnen des Nebenschlussschalters der Startbox, wenn die Strangspannung einen vordefinierten Schwellenwert überschreitet (der vordefinierte Schwellenwert ist z.B. die Startspannung am Wechselrichter),
- Schließen des Freischalters zum Anschließen des Wechselrichters an den Strang, und/oder
- Aufladen eines Eingangskondensators am Wechselrichter des Strangs bis die Lade-/Entladekurve des Eingangskondensators flach wird.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine perspektivische Darstellung einer typischen Solaranschlussdose,
- Fig. 2: ein Blockschaltbild eines Solarmoduls mit intelligenter Solaranschlussdose im Betriebszustand,
- Fig. 3: wie Fig. 2, aber im Sicherheitszustand,
- Fig. 4: ein Blockschaltbild einer Starterschaltung mit eigener Stromquelle im symbolisierten Strang mit einer Mehrzahl von Solarmodulen,
- Fig. 5: ein Blockschaltbild einer Starterschaltung ohne eigene Stromquelle im symbolisierten Strang mit einer Mehrzahl von Solarmodulen,
- Fig. 6: eine Übersichtsdarstellung eines Strangs der Photovoltaik-Anlage mit einer Mehrzahl von Solarmodulen mit intelligenter Solaranschlussdose, Wechselrichter und Startbox,
- Fig. 7: wie Fig. 6, mit einer weiteren Ausführungsform einer Startbox,
- Fig. 8: wie Fig. 7, mit einer weiteren Ausführungsform der Startbox und teilweise Solarmodulen mit nicht-intelligenten Solaranschlussdosen,
- Fig. 9: wie Fig. 6 mit einer weiteren Ausführungsform der Startbox und einem Wechselrichter mit Eingangskondensator,
- Fig. 10a: ein vereinfachtes prinzipielles Blockschaltbild für die Verschaltung der Startbox aus Fig. 4 im Betriebszustand der Photovoltaikanlage,
- Fig. 10b: wie Fig. 10a, aber im Startmodus der Startbox,
- Fig. 11: ein Ablaufdiagramm der Steuerung in der intelligenten Solaranschlussdose.

### Detaillierte Beschreibung der Erfindung

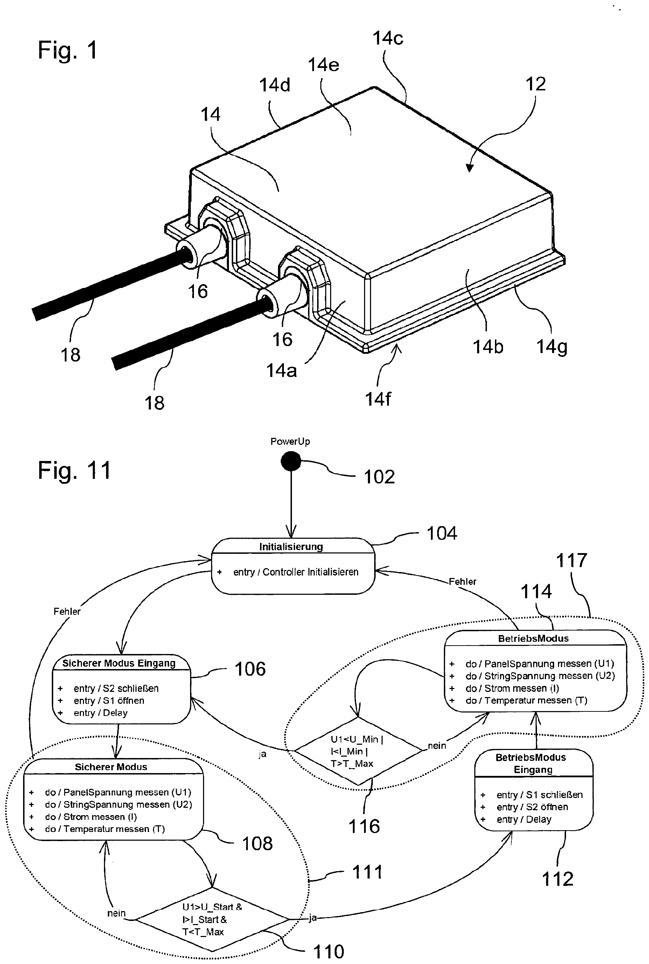

Fig. 1 zeigt eine Solaranschlussdose 12 mit einem Anschlussdosengehäuse 14 zur Montage auf der Rückseite eines Solarmoduls. Das dielektrische Anschlussdosengehäuse 14 ist hutartig ausgebildet und weist umlaufende Seitenwände 14a bis 14d sowie einen Deckel 14e auf. An der in Fig. 1 nicht zu sehenden Unterseite 14f des Anschlussdosengehäuses 14 befinden sich Öffnungen, durch welche die aus dem Solarmodul heraustretenden Leiterbänder in die Solaranschlussdose 12 eintreten, um dort kontaktiert zu werden. Das Anschlussdosengehäuse 14 weist an einer der Seitenwände 14a zwei Kabeldurchführungen 16 auf, durch welche die Strangleitung 18 in die Solaranschlussdose 12 geführt und im Inneren des Anschlussdosengehäuses 14 zum Beispiel mittels nicht dargestellter Kontaktklemmen angeschlossen ist, um die von dem Solarmodul erzeugte elektrische Leistung abzuführen. Ein Rand 14g dient zum Aufkleben der Solaranschlussdose auf dem Solarmodul. Zum grundsätzlichen konstruktiven Aufbau von Solaranschlussdosen wird ferner auf die DE 10 2007 037 130 A1 und die DE 10 2007 042 547 A1 verwiesen.

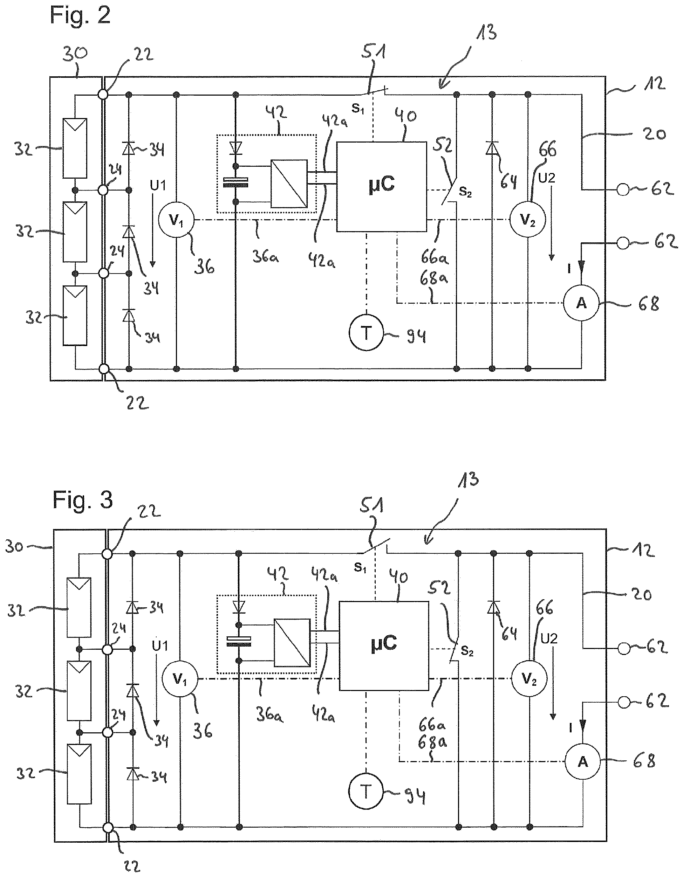

Fig. 2 zeigt ein Blockschaltbild der Solaranschlussdose 12, welche mit eingangsseitigen Plus- und Minus-Anschlusselementen 22 sowie in diesem Beispiel mit zwei Zwischenabgriffen 24 mit den entsprechenden Leiterbändern des Solarmoduls 30 verbunden sind. Parallel zu den Solarzellen oder Solar-Teilmodulen 32 sind Bypass-Dioden 34 geschaltet, um Teilabschattungen des Solarmoduls 30 kompensieren zu können.

Die Solaranschlussdose 12 umfasst eine Sicherheitsschaltung 13, welche die Solaranschlussdose 12 vom Betriebszustand oder Betriebsmodus in den Sicherheitszustand oder Sicherheitsmodus und umgekehrt schalten kann und nachfolgend genauer beschrieben wird.

Ein parallel zu dem Solarmodul 30 geschalteter Spannungssensor 36 (V₁) misst die Modulspannung U1 und wird über die Verbindung 36a von einer Steuereinrichtung in Form eines Mikrocontrollers 40 ausgelesen. Ferner parallel zu dem Solarmodul 30 ist eine Energieversorgungseinrichtung 42 geschaltet, welche den Mikrocontroller 40 über Versorgungsleitungen 42a mit Energie versorgt, damit dieser die Solaranschlussdose 12 steuern kann. Seriell zu dem Solarmodul 30 ist in der Solaranschlussdose 12 ein serieller Freischalter 51 (S1) in dem Strang 20 eingebaut, welcher in dem in Fig. 2 dargestellten Betriebszustand geschlossen ist, um die von dem Solarmodul 30 photovoltaisch erzeugte Leistung über den Strang 20 abzuführen. Ausgangsseitige Plus- und Minus-Anschlusselemente 62 sind mit einem Kurzschlussschalter 52 (S2) in der Solaranschlussdose 12 kurzschließbar, wobei der Kurzschlussschalter 52 in dem Betriebszustand geöffnet ist. Eine zentrale Bypass-Diode 64 zwischen den Plus- und Minus-Anschlusselementen 62 und dem Kurzschlussschalter 52 erzeugt einen weiteren Bypass, zum Beispiel für den Fall einer Fehlfunktion des Kurzschlussschalters 52.

Ein ausgangsseitiger Spannungssensor 66 misst die Strangspannung (U2), unabhängig vom Schaltzustand der Schalter 51 und 52, und wird über die Verbindung 66a von dem Mikrocontroller 40 ausgelesen. Ein Stromsensor 68 misst sowohl den Strangstrom in dem in Fig. 2 dargestellten Betriebszustand, als auch den Startstrom, bzw. detektiert das Startsignal in dem in Fig. 3 dargestellten Sicherheitszustand und wird über die Verbindung 68a von dem Mikrocontroller 40 ausgelesen. Der Mikrocontroller 40 liest den eingangsseitigen Spannungssensor 36, den ausgangsseitigen Spannungssensor 66 und den Stromsensor 68 aus und steuert in Ansprechen auf die Messwerte den Freischalter 51 und den Kurzschlussschalter 52.

Fig. 3 zeigt ein Blockschaltbild der intelligenten Solaranschlussdose 12 in dem Sicherheitszustand. Im Sicherheitszustand ist der Freischalter 51 geöffnet und der Kurzschlussschalter 52 geschlossen, so dass das Solarmodul 30 einerseits von dem Strang 20 getrennt ist und der Strang 20 mittels des Kurzschlussschalters 52 kurzgeschlossen ist. Auch in dem Sicherheitszustand wird die Energieversorgung 42 von dem zugehörigen Solarmodul 30 mit Energie versorgt, sofern das Solarmodul 30 beleuchtet wird. Die Energieversorgung 42 wiederum versorgt den Mikrocontroller 40, so dass dieser auch im Sicherheitszustand in Betrieb bleibt, solange die Einstrahlung ausreicht. Mit anderen Worten kann der Mikrocontroller 40 auch in dem in Fig. 3 dargestellten Sicherheitszustand die ein- und/oder ausgangsseitigen Spannungssensoren 36, 66 und/oder insbesondere den Stromsensor 68 auslesen und/oder die Schalter 51 und/oder 52 steuern. Vorzugsweise ist der Freischalter 51 als Schließer und/oder der Kurzschlussschalter 52 als Öffner ausgebildet, so dass der in Fig. 3 dargestellte Sicherheitszustand dem Ruhezustand der Schalter 51, 52 entspricht. Dies hat den Vorteil, dass spätestens wenn das Solarmodul mangels hinreichender Beleuchtung nicht mehr genug Leistung zum Versorgen des Mikrocontrollers 40 liefert, die intelligente Solaranschlussdose 12 automatisch in den Sicherheitszustand schaltet.

Wenn sich nun alle Solaranschlussdosen 12 eines Strangs 20 im Sicherheitszustand befinden, bedeutet dies, dass kein photovoltaisch erzeugter Strom fließt und der Sicherheitszustand nicht ohne Weiteres verlassen wird, selbst dann, wenn zum Beispiel die Sonne aufgeht und die Einstrahlung hinreichend stark ist. Ein einfaches Öffnen des Kurzschlussschalters 52 und Schließen des Freischalters 51 würde dazu führen, dass eine berührgefährliche Spannung entstehen kann, wenn dies mehrere Solaranschlussdosen 12 zur selben Zeit machen würden. Daher ist ein dieser Erfindung zugrunde liegendes Problem, sicherzustellen dass der Stromkreis des Strangs 20 geschlossen ist, wenn die Solarmodule photovoltaisch erzeugte Spannung an den Strang anlegen, damit keine so genannte Offenspannung bei nicht geschlossenem Stromkreis an möglicherweise offenen Kontakten anliegen kann.

Hierzu wird nun ein Startstrom von einer externen Startbox in den auch im Sicherheitszustand der Solaranschlussdosen 12 geschlossenem Stromkreis des Strangs 20 in den Strang eingeprägt.

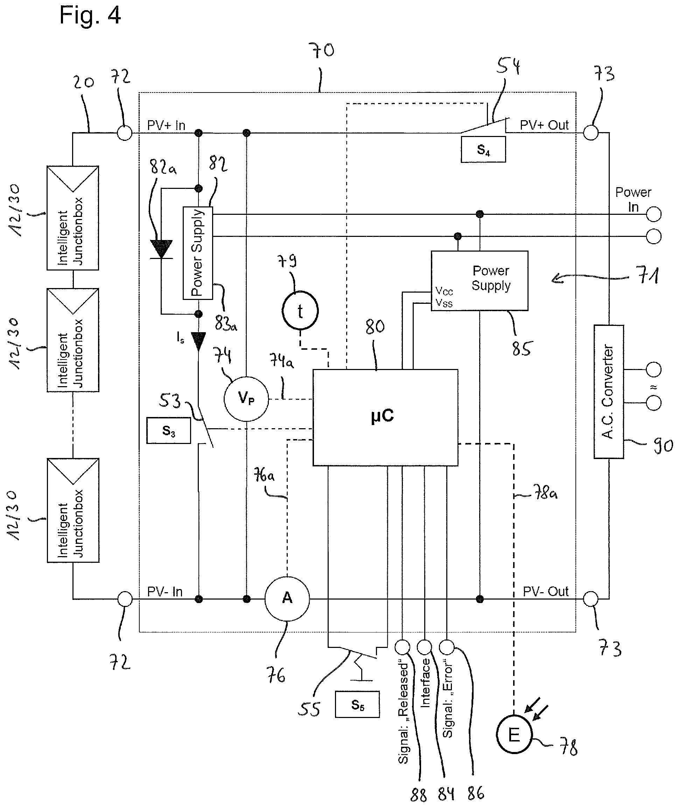

Bezug nehmend auf Fig. 4 ist die Startbox 70 an den Strang 20 mit den Solarmodulen 30 und ihren intelligenten Solaranschlussdosen 12 angeschaltet und befindet sich in dem in Fig. 4 dargestellten Zustand zum Normalbetrieb der Photovoltaik-Anlage 1. In diesem Beispiel ist die Startbox 70 in beide Leitungen (Plus- und Minus-Leitung) des Strangs - d.h. beidseitig zweipolig - in Reihe zwischen die seriell geschalteten Solarmodule 30 und den Wechselrichter 90 geschaltet. Hierzu ist die Startbox 70 über zwei Eingangsanschlüsse 72 mit dem Solargenerator, bestehend aus den Solarmodulen 30 verbunden und über die zwei Ausgangsanschlüsse 73 ist die Startbox 70 mit dem Wechselrichter verbunden. Ein Spannungssensor 74 (V_{P}) misst die Strangspannung U3. Ein Stromsensor 76 (A) misst den Strom auf dem Strang, welches entweder der photovoltaisch erzeugte Solarstrom im Betriebszustand oder der Startstrom im Sicherheitszustand bzw. Startmodus sein kann. Ein Einstrahlungssensor 78 misst das vorhandene Licht. Ein Controller oder Mikrocontroller 80 ist über Verbindungen 74a, 76a, 78a mit dem Spannungssensor 74, dem Stromsensor 76 bzw. dem Einstrahlungssensor 78 verbunden und liest diese aus, um sowohl die Strangspannung, als auch den Strom auf dem Strang und die Einstrahlung zu überwachen und im Ansprechen auf diese Messwerte die Starterschaltung 71 in der Startbox 70 zu steuern.

Die Starterschaltung weist in diesem Beispiel eine interne Stromquelle 82 auf, zu welcher eine Diode 82a in Durchlassrichtung zum Solarstrom parallel geschaltet ist. Der Mikrocontroller 80 steuert einen, in Bezug auf den Strang 20 mit den Solarmodulen 30, zur Stromquelle 82 parallelen und zum Wechselrichter 90 seriellen Freischalter 54 und/oder einen, in Bezug auf den Strang 20 mit den Solarmodulen 30 und zur Stromquelle 82, seriellen ersten Schalter 53. Die Stromquelle 82 ist in diesem Beispiel als internes Netzteil 83a der Startbox 70 vorgesehen. In dem in Fig. 4 dargestellten Betriebszustand der Photovoltaik-Anlage 1 ist der Freischalter 54 geschlossen und der zur Stromquelle 82 serielle erste Schalter oder Nebenschlussschalter 53 ist geöffnet, so dass die dargestellte Starterschaltung 71 in diesem Zustand nahezu verlustfrei ist und der photovoltaisch erzeugte Strom nahezu verlustfrei durch die Starterschaltung 71 zum Wechselrichter 90 fließen kann.

Zum Starten des Strangs 20 bzw. der intelligenten Solaranschlussdosen 12 ist der Freischalter 54 geöffnet und der Nebenschlussschalter 53 geschlossen. Nun wird der von der Stromquelle 82 erzeugte Startstrom I_{S} für eine vorbestimmte Zeit t_{S} in den Strang 20 eingeprägt. Die Photovoltaik-Anlage 1, das heißt die intelligenten Solaranschlussdosen 12 befinden sich hierbei zunächst noch im Sicherheitszustand, so dass einerseits der in den Strang eingeprägte Startstrom durch den Strang fließen kann und andererseits in diesem Beispiel kein photovoltaisch erzeugter Strom durch den Strang fließt.

In dem Sicherheitszustand ist also - sofern kein Störfall vorliegt - trotz Einzelfreischaltung der Solarmodule der Stromkreis der Strangleitung 18 geschlossen. Mittels des eingeprägten Startstroms I_{S} wird ein Stromfluss durch die geschlossene Strangleitung initiiert, welcher von den Stromsensoren 68 gemessen oder detektiert wird. In Ansprechen auf dieses Mess- oder Detektionsergebnis schalten dann die Sicherheitsschaltungen 13 automatisch vom Sicherheitszustand in den Betriebszustand um. Das Umschalten der Sicherheitsschaltungen 13 von dem Sicherheitszustand in den Betriebszustand kann also nur dann erfolgen, wenn der Stromkreis der Strangleitung 18 geschlossen ist.

Wenn in Ansprechen hierauf alle intelligenten Solaranschlussdosen 12 aktiviert wurden, d.h. vom Sicherheitszustand in den Betriebszustand umgeschaltet haben, wird der Nebenschlussschalter 53 wieder geöffnet und der Freischalter 54 wird wieder geschlossen, so dass nun der photovoltaisch erzeugte Strom durch den Strang 20 fließen und die entsprechende Photovoltaik-Leistung ins Netz eingespeist werden kann.

Falls das Starten oder die Startsequenz fehlschlägt, kann diese automatisch wiederholt werden, was ebenfalls von dem Mikrocontroller 80 gesteuert wird. Da der Mikrocontroller 80 mit dem Spannungssensor 74 und dem Stromsensor 76 die Strangspannung und den Strangstrom überwacht und auswertet können diese Messwerte zur Berechnung der Strangleistung und zur Steuerung der Schaltvorgänge herangezogen werden.

Mit einem manuellen Aktivierungsschalter 55 (S5) kann der Startvorgang an der Startbox 70 auch manuell initiiert werden, d.h. die Photovoltaik-Anlage 1 manuell gestartet und vom Sicherheitszustand in den Betriebszustand versetzt werden. Über eine elektronische Schnittstelle 84 des Mikrocontrollers 80 können diese Informationen zum Beispiel mit einem Computer ausgelesen werden. Der Mikrocontroller 80 weist ferner Signaleinrichtungen 86, 88 auf, zum Beispiel in Form von Leuchtdioden, welche an der Startbox 70 einen möglichen Fehlerzustand ("Error/Fehler") bzw. das Vorliegen des Sicherheitszustandes ("Released/frei geschaltet") anzeigen.

Das Starten kann ferner über die Schnittstelle 84 ("Interface") durch eine übergeordnete Steuerung initiiert werden oder der digitale Eingang, an dem der Aktivierungsschalter 55 angeschlossen ist, kann über eine übergeordnete Steuerung geschaltet werden. Mit anderen Worten kann über die Schnittstelle 84 demnach ein Startkommando für das Einprägen des Startstroms bzw. Startsignals gegeben werden.

Im täglichen Normalbetrieb, wird bei Sonnenaufgang der Strang automatisch von der Starterschaltung 71 gestartet, damit der Ertrag der Anlage gesichert ist. Dies kann durch festgelegte Zeitpunkte in Ansprechen auf eine Zeitsteuerung 79 oder durch Auslesen des Einstrahlungssensors 78, die ebenfalls von der Starterschaltung 71 umfasst bzw. an den Mikrocontroller 80 angeschlossen sind, gesteuert bzw. initiiert werden.

Nach Sonnenaufgang werden einerseits die Mikrocontroller 40 der intelligenten Solaranschlussdosen 12 von den zugehörigen Solarmodulen 30 mit Energie versorgt, so dass diese auch in dem zunächst noch vorliegenden Sicherheitszustand energetisch in die Lage versetzt sind, die intelligenten Solaranschlussdosen zu steuern, insbesondere vom Sicherheitszustand in den Betriebszustand umzuschalten.

Zum Starten prägt nun die Starterschaltung 71 bei bereits geöffnetem oder durch Öffnen des Freischalters 54 und durch Schließen des Nebenschlussschalters 53 aus der Stromquelle 82 den Startstrom I_{S} in den Strang 20 ein, welcher von den noch im Sicherheitszustand befindlichen intelligenten Solaranschlussdosen 12 mittels des Stromsensors 68 detektiert und in Ansprechen hierauf steuert der Mikrocontroller 40 die intelligente Solaranschlussdose 12 vom Sicherheitszustand in den Betriebszustand, in diesem Beispiel durch Schließen des Freischalters 51 und Öffnen des Kurzschlussschalters 52. In vorteilhafter Weise ist so sicher gestellt, dass das Initiieren des Startvorgangs in den intelligenten Solaranschlussdosen 12 nur gelingt, wenn der Stromkreis des Strangs 20 auch geschlossen ist, so dass keine gefährliche Offenspannung entstehen kann.

Die Starterschaltung 71 ermöglicht mit den Messgeräten 74 und 76 die Messung von Spannung und Strom des Strangs 20 und die Ausgabe der Werte über die Schnittstelle 84. Aus den Einzelwerten von Spannung und Strom 74, 76 kann die Leistung ermittelt werden und wird ebenfalls über die Schnittstelle 84 zur Verfügung gestellt. Ferner kann mit den Einzelwerten von Spannung und Strom 74, 76 die Funktion überwacht und das Ergebnis ebenfalls über die Schnittstelle 84 zur Verfügung gestellt werden. Ferner ermöglicht die Starterschaltung 71 optional die Erkennung von Lichtbögen in dem Strang 20 (die Lichtbogenerkennung ist nicht dargestellt) und die Ausgabe dieser Werte über die Schnittstelle 84. Die Schaltung 71 ermöglicht ferner die Erkennung von Diebstählen in dem Strang 20 und die Ausgabe des Ergebnisses über die Schnittstelle 84.

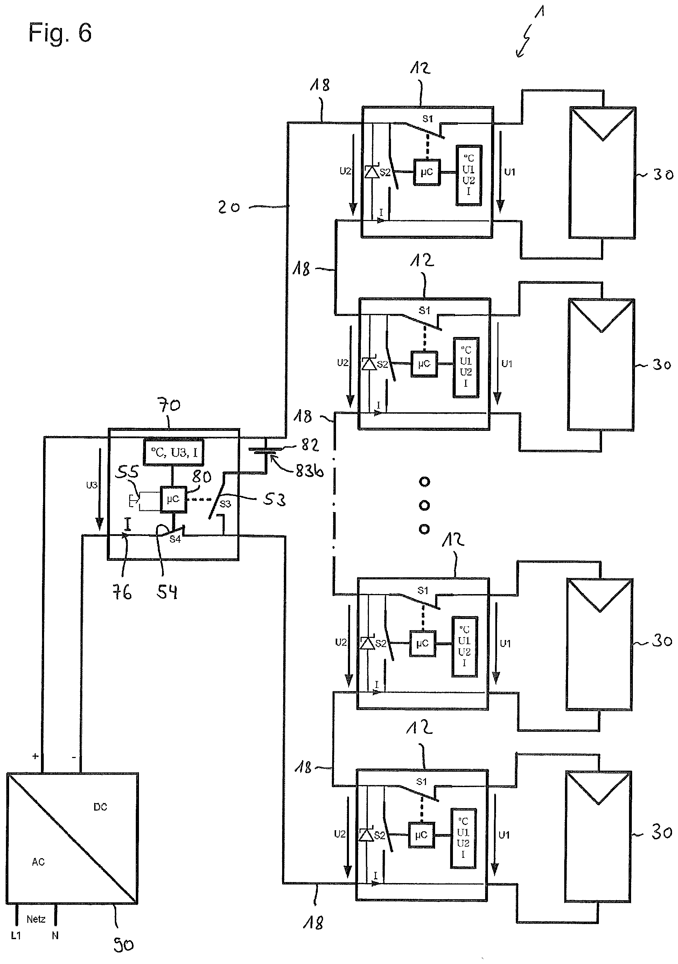

Fig. 6 zeigt ein Beispiel für die Anschaltung der Startbox 70 an den Strang 20 mit einer Mehrzahl von intelligenten Solaranschlussdosen 12. Im Unterschied zu der Startbox 70 in Fig. 4 ist die Stromquelle 82 extern an die Startbox 70 angeschlossen. In Fig. 6 ist der Strang 20 der Photovoltaik-Anlage 1 im Betriebzustand dargestellt, in welchem die intelligenten Solaranschlussdosen 12 im Betriebszustand sind und die Starterbox 70 inaktiv geschaltet ist, in dem der Nebenschlussschalter 53 (S3) geöffnet und der Freischalter 54 (S4) geschlossen sind.

In diesem Beispiel sind alle Solaranschlussdosen 12 "intelligent", so dass der Strang 20 bei Dunkelheit automatisch vollständig spannungsfrei schaltet oder im Stör- oder Wartungsfall vom Nutzer vollständig spannungsfrei geschaltet wird. Daher erfolgt die Energieversorgung der Starterschaltung 71 bzw. des Startstroms und des Mikrocontrollers 80 z.B. durch den Anschluss an das Versorgungsnetz, in diesem Beispiel durch ein externes Netzteil 83b als Stromquelle 82. Zum Einprägen des Startstroms und damit Starten der Photovoltaik-Anlage 1 wird der Freischalter 54 (S4) geöffnet und der zur Stromquelle 82 und dem Strang 20 serielle Nebenschlussschalter 53 (S3) geschlossen. Da der zum Strang 20 bzw. zu den Solarmodulen 30 serielle Nebenschlussschalter 53 (S3) zum Wechselrichter parallel geschaltet ist, ist der Stromkreis des Strangs 20 unter Umgehung des Wechselrichters 90 geschlossen, so dass der eingeprägte Startstrom durch den Strang 20 und die Solaranschlussdosen 12 im Sicherheitszustand fließen kann. In den intelligenten Solaranschlussdosen 12 wird der eingeprägte Startstrom gemessen bzw. das Startsignal detektiert und in Ansprechen hierauf werden die intelligenten Solaranschlussdosen 12 von dem jeweiligen Mikrocontroller 40 wieder vom Sicherheitszustand in den dargestellten Betriebszustand umgeschaltet.

Die intelligenten Solaranschlussdosen 12 überwachen in diesem Beispiel (symbolisch dargestellt) Temperatur °C, Modulspannung U1, Strangspannung U2 sowie den Strom I auf den Strang. Die Steuerung der intelligenten Solaranschlussdose 12 erfolgt in Ansprechen auf einen oder mehrere dieser gemessenen Werte. Die Startbox 70 überwacht ebenfalls den Strom I auf dem Strang, Temperatur °C und/oder die Strangspannung U3.

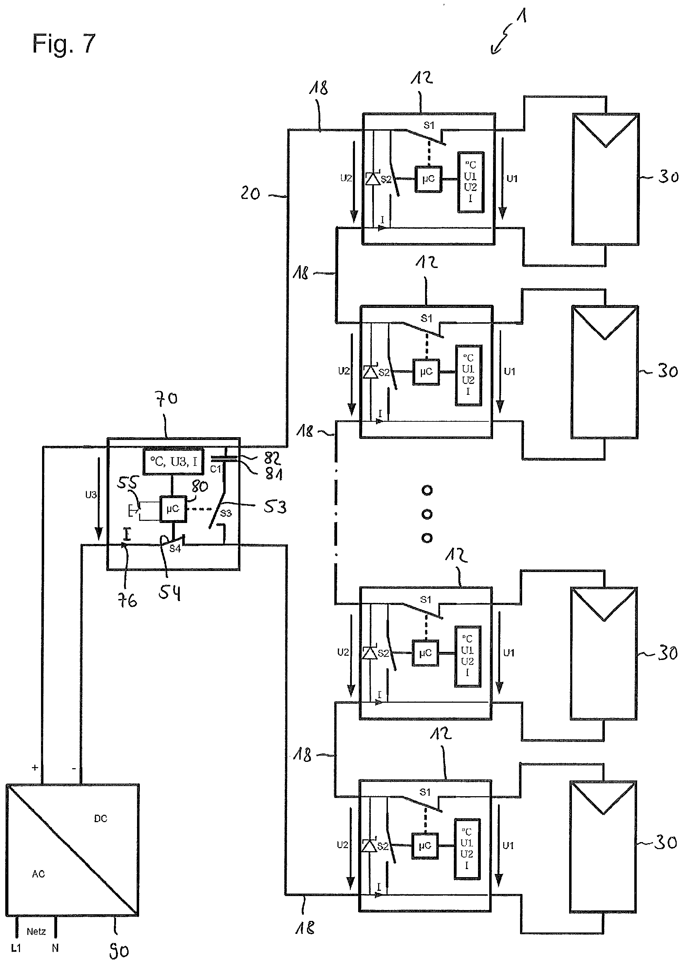

Fig. 7 zeigt den Strang 20 ebenfalls mit ausschließlich intelligenten Solaranschlussdosen 12 und einer geringfügig abgewandelten Ausführungsform der Starterbox 70. Anstatt des externen Netzteils 83b als Stromquelle 82 (Fig. 6) weist die Starterbox 70 in Fig. 7 einen (internen) Kondensator 81 (C1) als Stromquelle 82 auf. Die Sicherheitsschaltungen 13 der intelligenten Solaranschlussdosen 12 bzw. die Photovoltaikanlage 1 werden mittels des Nebenschlussschalters 53 (S3) wie folgt gestartet.

Wenn die Spannung U3 an der Startbox 70 einen unteren Schwellenwert U3ᵤ unterschreitet und/oder wenn der Mikrocontroller 80 ein Startsignal erhält, wird der Nebenschlussschalter 53 (S3) geschlossen und schließt somit den Stromkreis des Strangs 20 durch die intelligenten Solaranschlussdosen 12 und startet dadurch die Sicherheitsschaltungen 13 der intelligenten Solaranschlussdosen 12 und somit die Photovoltaikanlage 1. Bei diesem Starten wird der Nebenschlussschalter 53 (S3) zumindest solange geschlossen, bis die Spannung U3 einen oberen Schwellenwert U3ₒ von z.B. 200 V überschritten hat und wird dann wieder geöffnet. Danach ist die Kapazität 81 (C1) wieder geladen und für den nächsten Start bereit, der dann wiederum erfolgt, wenn die Spannung U3 wieder den unteren Schwellenwert U3ᵤ unterschreitet und/oder der Mikrocontroller erneut ein Startsignal erhält. Im Übrigen arbeitet die Startbox 70 in Fig. 7 wie die Startbox 70 in Fig. 6 mit der konstanten Stromversorgung durch das externe Netzteil 83b, so dass hierauf Bezug genommen werden kann.

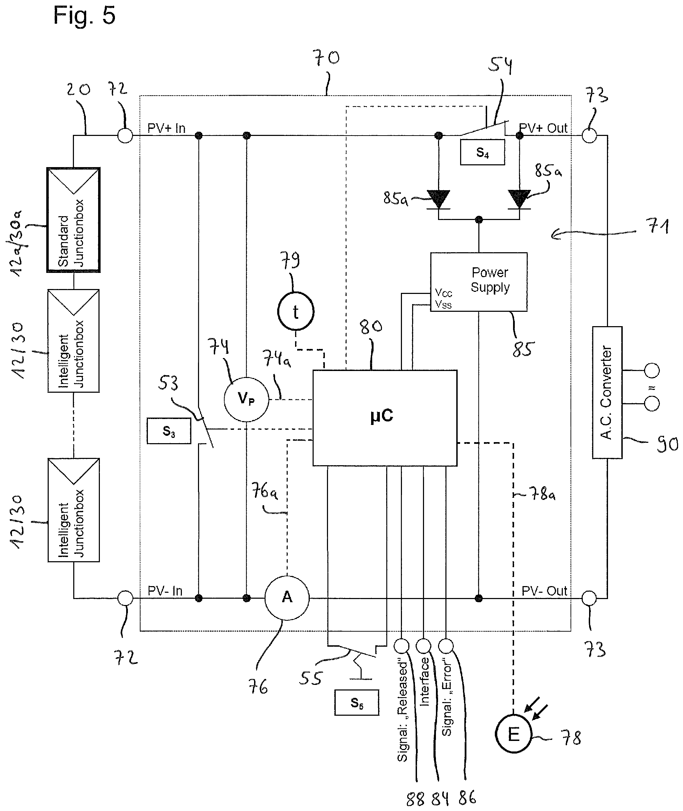

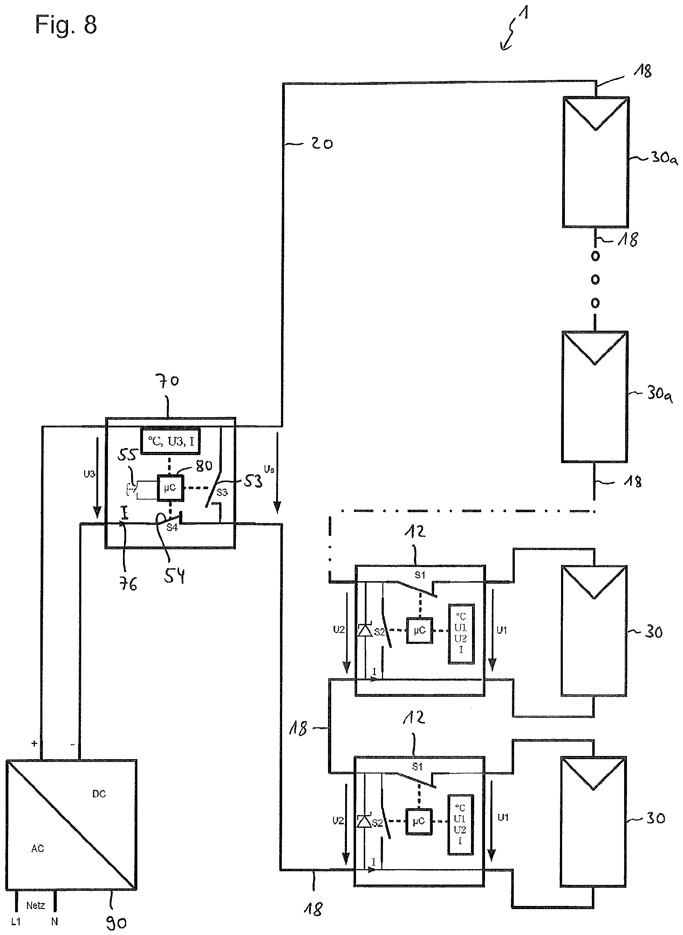

Die Fig. 5 und 8 zeigen eine weitere Ausführungsform des Strangs 20 mit Solarmodulen 30 mit intelligenten Solaranschlussdosen 12 sowie einem oder mehreren weiteren Solarmodule 30a mit einfachen konventionellen ("nicht-intelligenten" - ohne die besagte Sicherheitsschaltung) Solaranschlussdosen 12a, welche der Übersichtlichkeit halber in Fig. 8 nicht dargestellt sind. Mit anderen Worten werden die Solarmodule 30a nicht einzeln an- und abgeschaltet. Die Gesamtspannung der nicht-intelligenten Solarmodule 30a kann unter einer berührgefährlichen Spannung gehalten werden. Nach Sonnenaufgang sind zwar die intelligenten Solarmodule 30 noch vom Strang 20 abgeschaltet, das oder die nicht-intelligenten Solarmodule 30a legen aber ohne Weiteres Spannung an den Strang 20 an.

Allgemein hat also bei dieser Ausführungsform zumindest ein Solarmodul 30a keine intelligente Solaranschlussdose 12 und liefert im normalen Betrieb die notwendige Spannung, den Mikrocontroller 80 der Startbox 70 zu betreiben und den Startstrom für die übrigen intelligenten Solaranschlussdosen 12 des Strangs 20 zu liefern. Daher kann auf ein eigenes Netzteil 83a, 83b der Startbox verzichtet werden. Die Energieversorgung 85 des Mikrocontrollers 80 wird hier über in Durchlassrichtung gepolte Dioden 85a aus der Solarenergie des/der nicht-intelligenten Solarmoduls/e 30a gespeist. Dies spart Kosten bei der Anschaffung, Installation und Wartung.

In dem in den Fig. 5 und 8 dargestellten einfachen Beispiel wird, wenn sich die intelligenten Solaranschlussdosen 12 in dem in Fig. 3 dargestellten Sicherheitszustand befinden, zum Starten des Strangs der zum Strang 20 mit den Solarmodulen 30, 30a serielle Nebenschlussschalter 53 (S3) in der Startbox 70 geschlossen, so dass der Stromkreis des Strangs 20 geschlossen ist und der von den nicht-intelligenten Solarmodulen 30a photovoltaisch erzeugte Strom durch den Strang 20 fließt und den Startstrom bildet. Auch hier schließt also der Nebenschlussschalter 53 im Nebenschluss zu dem Wechselrichter 90 den Stromkreis mit den Solarmodulen 30, 30a, um den Startstrom bzw. das Startsignal in die Strangleitung einzuprägen.

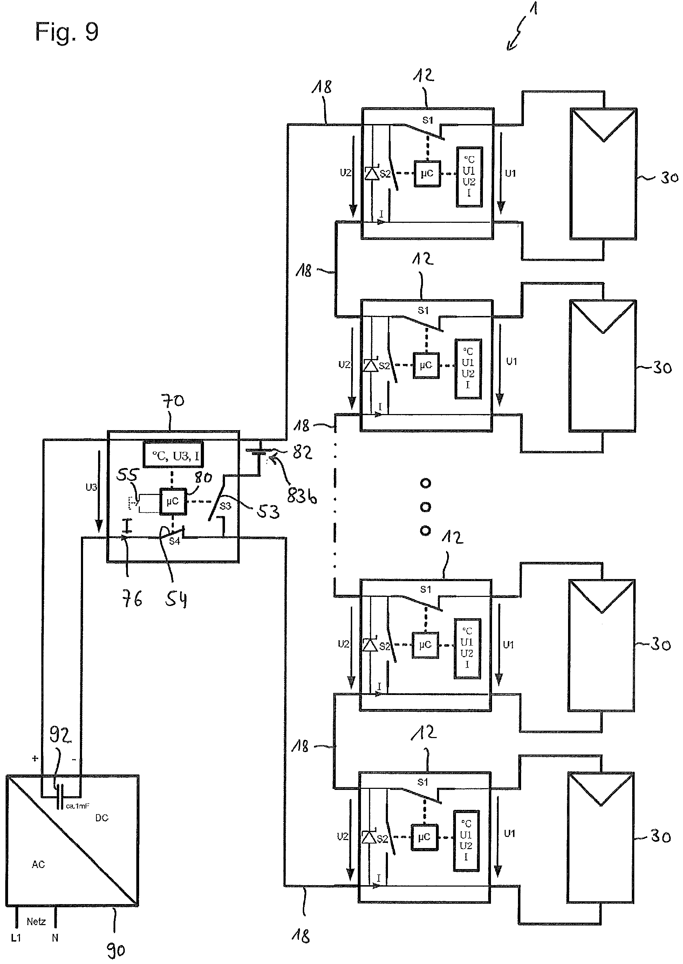

Fig. 9 zeigt eine weitere Ausführungsform des Strangs 20, bei dem der Wechselrichter 90 durch Pulsen aktiviert wird. Der Wechselrichter 90 besitzt eine Eingangskapazität 92 von etwa 1 mF auf der Gleichstromseite. Das Startverhalten des Wechselrichters 90 ist so aufgebaut, dass wenn eine ausreichend hohe Strangspannung zur Verfügung steht, der Wechselrichter 90 eine DC-Netz-Prüfung und anschließend eine solarnetzseitige Belastungsprüfung durchführt. Hierzu wird die Impedanz des Wechselrichters soweit gesenkt, bis sich durch die Belastung die Spannung entsprechend des Arbeitspunktes des Solargenerators auf einen Wert unterhalb der Leerlaufspannung verringert. Wenn nun ein Wert aus dem Produkt von Strom und Spannung entsteht, welcher oberhalb einer Wechselrichter-spezifischen Schwelle liegt, startet der Strang die Produktion von eingespeister photovoltaisch erzeugter Leistung. Dies bedeutet, dass ein hochimpedantes Grundverhalten beim Start des Wechselrichters 90 vorliegt. Ferner benötigt der Wechselrichter 90 eine gewisse Zeit zum Beispiel für eine Erdungsmessung.

Erfindungsgemäß trennt dann die Startbox 70 den Nebenschluss vom PV-Netz bzw. vom Strang 20, wenn eine Strangspannung U3 oberhalb der Schaltschwelle von der Startbox 70 erkannt wird. Am Wechselrichter 90 liegt die Summenspannung der Solarmodule 30 an, die ausreicht, um das Solarkraftwerk zu starten. Wird nun durch eine Fehlfunktion des Wechselrichters 90 der Stromfluss auf dem Strang 20 unterbrochen, kann der Startprozess erneut durchgeführt werden. Dies kann automatisch vom Mikrocontroller 80 der Startbox 70 oder über eine externe Steuerung, zum Beispiel über die Schnittstelle 84 oder den externen Aktivierungsschalter 55 (S5) durchgeführt werden, wobei diese gegebenenfalls mit einer Leitzentrale verbunden sind.

Die Ablaufsequenz bei dieser Ausführungsform läuft wie folgt ab:
1. Die Startbox 70 wird aktiviert, indem der Nebenschlussschalter 53 (S3) geschlossen wird,
2. Der Startstrom Iₖₒₙₛₜₐₙₜ wird aus der Stromquelle 82 (hier: externes Netzteil 83b) in den Strang 20 eingeprägt,
3. wenn die Startspannung am Wechselrichter 90 erreicht ist, wird die Startbox 70 wieder abgeschaltet, indem der Nebenschlussschalter 53 (S3) wieder geöffnet wird,
4. der Freischalter 54 (S4) der Startbox 70 wird getaktet geöffnet und geschlossen und der Kondensator 92 des Wechselrichters wird aufgeladen, bis die Lade-/Entladekurve flach wird (zum Beispiel < 5V/s).

Als Startstrom werden beispielsweise 500mA mit einer Spannung von 24V eingespeist. Wenn die Spannung U3 einen vorbestimmten Schwellenwert übersteigt, z.B. größer als 100V ist, wird der Nebenschlussschalter 53 (S3) geöffnet.

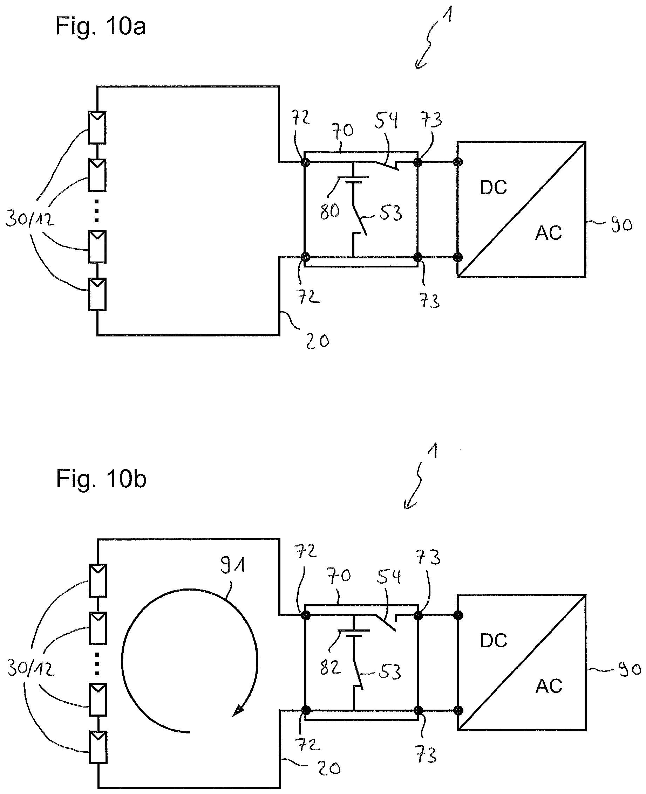

Fig. 10a/b zeigen ein vereinfachtes Blockschaltbild des Strangs 20 mit der Startbox 70 aus Fig. 4. Fig. 10a zeigt den Betriebszustand der Photovoltaikanlage 1 mit geöffnetem Nebenschlussschalter 53 und geschlossenem Freischalter 54. Fig. 10b zeigt die Photovoltaikanlage 1 mit der Startbox 70 im Startmodus, in dem der Nebenschlussschalter 53 geschlossen und der Freischalter 54 geöffnet sind.

Der Nebenschlussschalter 53 ist seriell zu der Stromquelle 82 geschaltet und die Startbox 70 bildet bei geschlossenem Nebenschlussschalter 53 unter Überbrückung des Wechselrichters 90 einen Stromkreis 91 mit den Solarmodulen 20. Demnach bildet die Startbox 70 bei geschlossenem Nebenschlussschalter 53 einen temporären Nebenschluss zu dem mittels dem Freischalter 54 vom Strang freigeschalteten Wechselrichter 90. Mit anderen Worten bildet die Startbox 70 im Startmodus eine Nebenschlussstromquelle (Fig. 10b). Wenn der Nebenschlussschalter 53 geöffnet ist, ist der durch die Startbox 70 schaltbare Nebenschluss geöffnet und der gewöhnliche Stromkreis für den Betriebszustand der Photovoltaikanlage 1 wird bei geschlossenem Freischalter 54 durch die seriell geschalteten Solarmodule 20 und den Wechselrichter 90 gebildet (Fig. 10a).

Die Schalter 51, 52 (S1, S2) der intelligenten Solaranschlussdosen 12 und/oder die Schalter 53, 54 (S3, S4) der Starterbox 70 können Relais, Halbleiterschalter, insbesondere Feldeffekttransistoren sein.

Fig. 11 zeigt ein Ausführungsbeispiel eines Regelungsalgorithmus der intelligenten Solaranschlussdosen 12. Nach einem "Power-Up" 102 wird der Mikrocontroller 40 in einem Startschritt 104 initialisiert. Anschließend wird in einem Schritt 106 nochmals der Sicherheitszustand sichergestellt, in dem nochmals Eingaben zum Schließen des Kurzschlussschalters 52 und zum Öffnen des Freischalters 51 gemacht werden. Nachfolgend erfolgt eine kurze Verzögerung. In Schritt 108 werden die Modulspannung U1, die Strangspannung U2, der Strom am Sensor 68 und die Temperatur am Temperatursensor 94 gemessen. Ein Prüfschritt 110 prüft ob die Modulspannung U1 einen Schwellenwert U_Start zum Starten überschreitet und ob der Strom am Sensor 68 einen Schwellenwert I_Start überschreitet und ob die Temperatur unterhalb eines bestimmten Schwellenwertes T_Max liegt. Solange nicht alle drei Kriterien erfüllt sind, bleibt die intelligente Solaranschlussdose 12 im Regelkreis 111 des Sicherheitszustandes, welcher von den Schritten 108, 110 gebildet wird.

Wenn die drei Kriterien des Prüfschritts 110 erfüllt sind, schließt der Mikrocontroller 40 den Freischalter 51, öffnet den Kurzschlussschalter 52 und es erfolgt wieder eine gewisse Verzögerung. Im Schritt Betriebsmodus 114 werden wiederum die Modulspannung U1, die Strangspannung U2, der Strangstrom I und die Temperatur T mit den Sensoren 36, 66, 68, 94 gemessen. Im Prüfschritt 116 wird geprüft, ob die Modulspannung U1 unterhalb eines Schwellenwertes U_Min oder der Strangstrom I unterhalb eines Schwellenwertes I_Min oder die Modultemperatur T oberhalb eines Schwellenwertes T_Max liegen. Ergibt diese Oder-Verknüpfung ein Nein, bleibt die intelligente Solaranschlussdose 12 im Regelkreis 117 des Betriebszustandes. Der Regelkreis 117 wird von den Schritten 114, 116 gebildet wird. Falls eine der Oder-Verknüpfungen im Schritt 116 zutrifft, folgt wiederum der Schritt 106, also die Einleitung des Sicherheitszustandes. Ferner können im Sicherheitszustand 111 und im Betriebszustand 117 Fehlermeldungen abgegeben werden, die wiederum die Initialisierung 104 auslösen. Im Übrigen ist ersichtlich, dass der Betriebszustand 117 und/oder der Sicherheitszustand 111 aktive Regelkreise umfassen, in welchen die Messwerte, z.B. der eingeprägte Startstrom oder das Startsignal, die Modulspannung U1, die Strangspannung U2 und/oder die Temperatur T abgefragt werden, um die Schaltvorgänge in Ansprechen auf diese Werte auszulösen.

Zusammenfassend wird eine Erfindung vorgestellt, welche intelligente Solaranschlussdosen 12 in einer Photovoltaik-Anlage 1 nach einer Abschaltung oder bei Sonnenaufgang vom Sicherheitszustand in dem Betriebszustand umschaltet, so dass der Ertrag der Anlage gesichert ist. Im Sicherheitszustand ist der Ausgang der intelligenten Solaranschlussdosen 12 kurzgeschlossen, so dass ein Strom über den Strang 20 fließen kann, aber keine Spannung ansteht. Das Umschalten der einzelnen Sicherheitsschaltungen 13 der Solaranschlussdosen 12 vom Sicherheitszustand in den Betriebszustand erfolgt automatisch in Ansprechen auf die Messung oder Detektion des durch die geschlossene Strangleitung fließenden Startstromes I_{S}. Somit gewährleistet die Erfindung nicht nur das einzelne Freischalten und Anschalten der Solarmodule 20, sondern insbesondere, dass das Anschalten der Solarmodule 20 nur dann vollzogen werden kann, wenn der Stromkreis der Strangleitung 18 geschlossen ist, so dass keine berührgefährliche Offenspannung entstehen kann. Der Betriebszustand der PV-Anlage 1 ist eigenstabil, solange die PV-Anlage 1 hinreichende Solarleistung erzeugt, d.h. wenn die PV-Anlage 1 einmal gestartet wurde, verbleiben die Sicherheitsschaltungen 13 im Betriebszustand, solange der von der PV-Anlage 1 erzeugte Solarstrom und/oder die Solarspannung über vordefinierten Schwellwerten liegen, ohne dass es der Starterschaltung 71 bedarf. Mit anderen Worten wird die Starterschaltung 71 verwendet, um die PV-Anlage 1 sicher anzuschalten, ist aber nicht notwendig, um die PV-Anlage 1 im Betriebszustand zu halten, nachdem sie angeschaltet wurde. Daher kann die Starterschaltung 71, nachdem die PV-Anlage 1 in den Betriebszustand versetzt wurde, inaktiv geschaltet werden, wozu in diesem Beispiel die Starterschaltung 71 durch Öffnen des Nebenschlussschalters 53 (S3) und Schließen des Freischalters 54 (S4) auf Durchlass geschaltet wird. Im Betriebszustand werden keine elektronischen Komponenten der Starterschaltung 71 im seriellen Strang benötigt, die Leistungsverlust bzw. Energieverbrauch erzeugen können. Hierdurch können Störanfälligkeit und Leistungsverlust bzw. Energieverbrauch reduziert werden.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann.

## Patentansprüche

1. Photovoltaik-Anlage (1) mit zumindest einem Strang (20) aus seriell zusammengeschalteten Solarmodulen (30) und ausgebildet zum einzelnen Freischalten der Solarmodule (30) und zum sicheren erstmaligen Anschalten oder Wiederanschalten der freigeschalteten Solarmodule (30) an den Strang (20), umfassend:
eine Mehrzahl von Solarmodulen (30), welche jeweils eine Solaranschlussdose (12) umfassen, wobei die Solaranschlussdosen (12) jeweils eingangsseitige Plus- und Minus-Anschlusselemente (22), welche an die spannungsführenden Leiter des Pluspols bzw. Minuspols des zugehörigen Solarmoduls (30) angeschlossen sind und jeweils ausgangsseitige Plus- und Minus-Anschlusselemente (62) aufweisen,
wobei die Solarmodule (30) seriell mittels einer an die ausgangsseitigen Plus- und Minus-Anschlusselemente (62) angeschlossenen Strangleitung (18) zu dem Strang (20) verbunden sind,
wobei zumindest eine der Solaranschlussdosen (30) eine Sicherheitsschaltung (13) aufweist, die einen Kurzschlussschalter (52) zwischen den ausgangsseitigen Plus- und Minus-Anschlusselementen (62) und einen seriell in den Strang geschalteten Freischalter (51) umfasst, und die einen Betriebszustand (117) definiert, in welchem bei geschlossenen Freischalter (51) und geöffnetem Kurzschlussschalter (52) der von dem zugehörigen Solarmodul (30) erzeugte Solarstrom durch die Solaranschlussdose (12) über die Strangleitung (18) abgeführt wird, und die einen Sicherheitszustand (111) definiert, in welchem bei geöffnetem Freischalter (51) und geschlossenem Kurzschlussschalter (52) das zugehörige Solarmodul (30) in Bezug auf die angeschlossene Strangleitung (18) mittels der Sicherheitsschaltung (13) freigeschaltet und die Strangleitung über den geschlossenen Kurzschlussschalter (52) trotzdem geschlossen ist,
eine an die Strangleitung (18) angeschlossene Starterschaltung (71), welche dazu ausgebildet ist, einen Startstrom in den über den geschlossenen Kurzschlussschalter (52) geschlossenen Stromkreis der Strangleitung (18) einzuprägen,
wobei die Sicherheitsschaltung (13) einen Stromsensor (68) aufweist und dazu ausgebildet ist, in Ansprechen auf den von dem Stromsensor gemessenen oder detektierten durch den mittels des Kurzschlussschalters (52) geschlossenen Stromkreis der Strangleitung (18) fließenden Startstroms automatisch vom Sicherheitszustand (111) in den Betriebszustand (117) umzuschalten.

2. Photovoltaik-Anlage (1) nach Anspruch 1,
wobei die Starterschaltung (71) in einer separat von den Solarmodulen (30) an die Strangleitung (18) angeschlossenen Startbox (70) untergebracht ist.

3. Photovoltaik-Anlage (1) nach einem der vorstehenden Ansprüche, wobei der Startstrom einen Konstantstrom und/oder einen oder mehrere Strompulse umfasst, die durch die mittels des Kurzschlussschalters (52) geschlossene Strangleitung (18) fließen.

4. Photovoltaik-Anlage (1) nach einem der vorstehenden Ansprüche, wobei die Sicherheitsschaltung (13) eine Steuereinrichtung (40) umfasst, welche in Ansprechen auf den in die Strangleitung (18) eingeprägten Startstrom den Freischalter (51) schließt und/oder den Kurzschlussschalter (52) öffnet.

5. Photovoltaik-Anlage (1) nach Anspruch 4,
wobei die Steuereinrichtung (40) in dem Sicherheitszustand (111) von dem zugehörigen Solarmodul (30) mit elektrischer Leistung versorgt wird, wenn das zugehörige Solarmodul (30) von Licht beschienen wird, damit die Steuereinrichtung (40) die Sicherheitsschaltung (13) von dem Sicherheitszustand (111) in den Betriebszustand (117) umschalten kann.

6. Photovoltaik-Anlage (1) nach einem der vorstehenden Ansprüche, wobei der Stromsensor (68) im Sicherheitszustand den eingeprägten Startstrom misst oder detektiert und im Betriebszustand den in den Strang eingespeisten Solarstrom misst.

7. Photovoltaik-Anlage (1) nach einem der vorstehenden Ansprüche, wobei die Sicherheitsschaltung (13) derart ausgebildet ist, dass sie bei Abschattung des zugehörigen Solarmoduls (30) oder bei allgemeiner Dunkelheit und dem damit verbundenen Abfall der Modulspannung automatisch von dem Betriebszustand (117) in den Sicherheitszustand (111) schaltet.

8. Photovoltaik-Anlage (1) nach einem der vorstehenden Ansprüche, wobei die Solaranschlussdose (12) zumindest eine der folgenden Einrichtungen aufweist:
- einen ersten Spannungssensor (36), welcher die Modulspannung (U1) des zugehörigen Solarmoduls (30) misst,
- einen zweiten Spannungssensor (66), welcher die Strangspannung (U2) misst,
- einen Temperatursensor (94) welcher die Temperatur des zugehörigen Solarmoduls (30) überwacht,
wobei die Steuereinrichtung (40) den ersten Spannungssensor (36) und/oder den zweiten Spannungssensor (66) und/oder den Temperatursensor ausließt (94) und in Ansprechen hierauf die Sicherheitsschaltung (13) steuert.

9. Photovoltaik-Anlage (1) nach einem der vorstehenden Ansprüche, wobei alle Solarmodule (30) eines Strangs (20) eine Solaranschlussdose (12) mit der Sicherheitsschaltung (13) aufweisen, die einen Betriebszustand (117) definiert, in welchem der von dem zugehörigen Solarmodul (30) erzeugte Solarstrom durch die Solaranschlussdose (12) über die Strangleitung (18) an das Stromnetz abgeführt wird, und die einen Sicherheitszustand (111) definiert, in welchem die Sicherheitsschaltung das zugehörige Solarmodul (30) in Bezug auf die angeschlossene Strangleitung (18) spannungsfrei schaltet.

10. Startbox (70) mit einer Starterschaltung (71) ausgebildet zum Anschließen an die Strangleitung (18) einer Photovoltaik-Anlage (1) gemäß einem der vorstehenden Ansprüche und zum Einprägen des Startstroms in den geschlossenen Stromkreis der Strangleitung (18), um das Umschalten der Sicherheitsschaltung (13) vom Sicherheitszustand (111) in den Betriebszustand (117) zu bewirken.

11. Intelligente Solaranschlussdose (12) zum Montieren auf einem Solarmodul (30) und zum Anschließen an die Strangleitung (18) einer Photovoltaik-Anlage (1) gemäß einem der Ansprüche 1-9, umfassend:
eingangsseitige Plus- und Minus-Anschlusselemente (22) zum Anschließen der spannungsführenden Leiter des Pluspols bzw. Minuspols des zugehörigen Solarmoduls (30) und jeweils ausgangsseitige Plus- und Minus-Anschlusselemente (62) zum Anschließen der Strangleitung (18),
eine Sicherheitsschaltung (13), die einen Kurzschlussschalter (52) zwischen den ausgangsseitigen Plus- und Minus-Anschlusselementen (62) und einen seriell in den Strang geschalteten Freischalter (51) umfasst, und die einen Betriebszustand (117) definiert, in welchem bei geschlossenen Freischalter (51) und geöffnetem Kurzschlussschalter (52) der von dem zugehörigen Solarmodul (30) erzeugte Solarstrom durch die Solaranschlussdose (12) über die Strangleitung (18) abgeführt wird, und die einen Sicherheitszustand (111) definiert, in welchem bei geöffnetem Freischalter (51) und geschlossenem Kurzschlussschalter (52) das zugehörige Solarmodul (30) in Bezug auf die angeschlossene Strangleitung (18) mittels der Sicherheitsschaltung (13) freigeschaltet und die Strangleitung über den geschlossenen Kurzschlussschalter (52) trotzdem geschlossen ist,
wobei die Sicherheitsschaltung (13) einen Stromsensor (68) aufweist und dazu ausgebildet ist, in Ansprechen auf einen von dem Stromsensor gemessenen oder detektierten durch den mittels des Kurzschlussschalters (52) geschlossenen Stromkreis der Strangleitung (18) fließenden Startstrom automatisch vom Sicherheitszustand (111) in den Betriebszustand (117) umzuschalten.

12. Verfahren zum sicheren Einschalten eines Strangs (20) aus seriell geschalteten Solarmodulen (30) einer Photovoltaik-Anlage (1), wobei die Sicherheitsschaltungen (13) einen Sicherheitszustand (111) definieren, in welchem die Solarmodule (30) in Bezug auf die Strangleitung (18) einzeln spannungsfrei geschaltet sind und die Strangleitung (18) bei Störungsfreiheit trotzdem geschlossen ist, umfassend folgende Schritte:
Einprägen eines Startstroms in den geschlossenen Stromkreis der Strangleitung (18),
Messen oder Detektieren des durch den geschlossenen Stromkreis der Strangleitung (18) fließenden Startstroms, und
automatisches Anschalten der Solarmodule (30) an den Strang (20) mittels der Sicherheitsschaltung (13) der zugehörigen Solaranschlussdose (12) in Ansprechen auf das Mess- oder Detektionsergebnis des durch den geschlossenen Stromkreis der Strangleitung (18) fließenden Startstroms, so dass sichergestellt ist, dass die Strangleitung (18) geschlossen ist und keine Offenspannung entstehen kann, wenn die erzeugte Solarleistung nach dem automatischen Anschalten der Solarmodule (30) über den Strang (20) abgeführt wird.

13. Verfahren nach Anspruch 12,
wobei das Einprägen des Startstroms von einer an den Strang (20) angeschalteten zentralen Startbox (70) gesteuert wird und zwar in Ansprechen auf:
- Manuelles Betätigen eines Aktivierungsschalters (55) an der Startbox (70) und/oder
- ferngesteuertes Starten der Starterschaltung (71) durch Senden eines Startsignals an eine Schnittstelle (84) des Controllers (80) der Starterschaltung (71) und/oder
- automatisches Starten in Ansprechen auf eine Zeitsteuerung (79) und/oder
- automatisches Starten in Ansprechen auf die Auswertung eines an die Starterschaltung (71) der Startbox (70) angeschlossenen Einstrahlungssensors (78) .

14. Verfahren nach Anspruch 12 oder 13,
wobei der in die Strangleitung (18) eingeprägte Startstrom gespeist wird:
- von einer eigenen Stromquelle (82) an der Starterschaltung (71) und/oder
- einem Solarmodul (30a) des Strangs mit einer Solaranschlussdose ohne die Sicherheitsschaltung (13), so dass dieses Solarmodul (30a) nicht in einen Sicherheitszustand (111) versetzt wird.

15. Verfahren nach einem der Ansprüche 12 bis 14, wobei zum Anschalten der Solaranschlussdosen (12) an den Strang (20) einer oder mehrere der folgenden Schritte in der Starterschaltung (71) durchgeführt werden:
- Öffnen des Freischalters (54) der Startbox (70) zum Freischalten des Wechselrichters (90),
- Schließen des ersten Schalters (53) der Startbox (70) zum Schließen des Stromkreises des Strangs (20) über die Starterschaltung (71) und Einprägen des Startstroms in die Strangleitung (18),
- Messen der Strangspannung (U3) in der Startbox (70),
- Trennen der Stromquelle (82) vom Strang (20) zum Beenden des Einprägens des Startstroms in den Strang (20), wenn die Strangspannung (U3) einen vordefinierten Schwellenwert überschreitet,
- Schließen des Freischalters (54) zum Anschließen des Wechselrichters (90) an den Strang.

## Claims

1. A photovoltaic system (1) comprising at least one string (20) of series-connected solar modules (30) and adapted for individually disconnecting the solar modules (30) and for safely initially connecting or reconnecting the disconnected solar modules (30) to the string (20), comprising:
a plurality of solar modules (30) each one comprising a solar junction box (12), said solar junction boxes (12) each having input-side positive and negative connection elements (22) connected to the voltage-carrying conductors of the positive and negative poles of the associated solar module (30), and each having positive and negative output-side connection elements (62);
wherein the solar modules (30) are connected in series to form said string (20) by means of a string line (18) connected to said output-side positive and negative connection elements (62);
wherein at least one of said solar junction boxes (30) includes a safety circuit (13) which comprises a short-circuiting switch (52) between the output-side positive and negative connection elements (62) and an isolating switch (51) connected in series into the string, and which defines an operating state (117) in which, with the isolating switch (51) closed and the short-circuiting switch (52) open, the solar power produced by the associated solar module (30) is delivered through the solar junction box (12) via the string line (18), and which defines a safe state (111) in which, with the isolating switch (51) open and the short-circuiting switch (52) closed, the associated solar module (30) is disconnected with respect to the connected string line (18) by means of the safety circuit (13) while the string line is nevertheless closed via the closed short-circuiting switch (52);
a starter circuit (71) connected to the string line (18) and adapted to inject a starting current into the string line (18) that is closed via the closed short-circuiting switch (52);
wherein the safety circuit (13) includes a current sensor (68) and is adapted to be responsive to the starting current which is measured or detected by the current sensor and which flows through the string line (18) that is closed by means of the short-circuiting switch (52), to automatically switch from the safe state (111) into the operating state (117).

2. The photovoltaic system (1) according to claim 1, wherein the starter circuit (71) is accommodated in a start box (70) which is connected to the string line (18) separately from the solar modules (30).

3. The photovoltaic system (1) according to any one of the preceding claims, wherein the starting current comprises a constant current and/or one or more current pulses flowing through the string line (18) that is closed by means of the short-circuiting switch (52).

4. The photovoltaic system (1) according to any one of the preceding claims, wherein the safety circuit (13) comprises a control device (40) which is responsive to the starting current injected into the string line (18) to close the isolating switch (51) and/or to open the short-circuiting switch (52).

5. The photovoltaic system (1) according to claim 4, wherein in the safe state (111), the control device (40) is supplied with electric power by the associated solar module (30) when the associated solar module (30) is exposed to light, so that the control device (40) is able to switch the safety circuit (13) from the safe state (111) into the operating state (117).

6. The photovoltaic system (1) according to any one of the preceding claims, wherein in the safe state, the current sensor (68) measures or detects the injected starting current, and in the operating state it measures the solar current fed into the string.

7. The photovoltaic system (1) according to any one of the preceding claims, wherein the safety circuit (13) is adapted so as to automatically switch from the operating state (117) into the safe state (111) when the associated solar module (30) is shadowed or in the case of general darkness and the associated drop of module voltage.

8. The photovoltaic system (1) according to any one of the preceding claims, wherein the solar junction box (12) comprises at least one of the following devices:
- a first voltage sensor (36) which measures the module voltage (U1) of the associated solar module (30);
- a second voltage sensor (66) which measures the string voltage (U2);
- a temperature sensor (94) which monitors the temperature of the associated solar module (30);
wherein the control device (40) reads out the first voltage sensor (36) and/or the second voltage sensor (66) and/or the temperature sensor (94) and controls the safety circuit (13) in response thereto.

9. The photovoltaic system (1) according to any one of the preceding claims, wherein all solar modules (30) of a string (20) have a solar junction box (12) including the safety circuit (13) which defines an operating state (117) in which the solar power produced by the associated solar module (30) is delivered to the power grid through the solar junction box (12) via the string line (18), and which defines a safe state (111) in which the associated solar module (30) is disconnected from voltage with respect to the connected string line (18).

10. A start box (70), comprising a starter circuit (71) adapted for being connected to the string line (18) of a photovoltaic system (1) according to any one of the preceding claims and for injecting the starting current into the closed circuit of the string line (18) to cause the safety circuit (13) to switch from the safe state (111) into the operating state (117).

11. A smart solar junction box (12) for being mounted to a solar module (30) and for being connected to the string line (18) of a photovoltaic system (1) according to any one of claims 1 to 9, comprising:
input-side positive and negative connection elements (22) for connecting the voltage-carrying conductors of the positive and negative poles of the associated solar module (30) and respective output-side positive and negative connection elements (62) for connecting the string line (18);
a safety circuit (13) which comprises a short-circuiting switch (52) between the output-side positive and negative connection elements (62) and an isolating switch (51) connected in series into the string, and which defines an operating state (117) in which the solar power generated by the associated solar module (30) is delivered through the solar junction box (12) via the string line (18) while the isolating switch (51) is closed and the short-circuiting switch (52) is open, and which defines a safe state (111) in which, with the isolating switch (51) open and the short-circuiting switch (52) closed, the associated solar module (30) is disconnected with respect to the connected string line (18) by means of the safety circuit (13) while the string line is nevertheless closed via the closed short-circuiting switch (52);
wherein the safety circuit (13) includes a current sensor (68) and is adapted to be responsive to a starting current which is measured or detected by the current sensor and which flows through the electrical circuit of the string line (18) that is closed by means of the short-circuiting switch (52), to automatically switch from the safe state (111) into the operating state (117).

12. A method for safely switching on a string (20) of series-connected solar modules (30) of a photovoltaic system (1), wherein the safety circuits (13) define a safe state (111) in which the solar modules (30) are individually disconnected from voltage with respect to the string line (18) while the string line (18) is nevertheless closed in case of fault-free operation, comprising the steps of:
injecting a starting current into the closed electrical circuit of the string line (18);
measuring or detecting the starting current flowing through the closed electrical circuit of the string line (18); and
automatically connecting the solar modules (30) to the string (20) by means of the safety circuit (13) of the associated solar junction box (12) in response to the result of measuring or detecting the starting current flowing through the closed circuit of the string line (18) so as to ensure that the string line (18) is closed and no open voltage can occur when the generated solar power is delivered via the string (20) after the automatic connection of the solar modules (30).

13. The method according to claim 12,
wherein the injecting of the starting current is controlled by a central start box (70) connected to the string (20) in response to:
- manual actuation of an enable switch (55) on the start box (70); and/or
- remotely controlled starting of the starter circuit (71) by transmitting a start signal to an interface (84) of the controller (80) of the starter circuit (71); and/or
- automatically starting in response to a timer (79); and/or
- automatically starting in response to an evaluation of an irradiation sensor (78) connected to the starter circuit (71) of the start box (70).

14. The method according to claim 12 or 13, wherein the starting current injected into the string line (18) is supplied by:
- an own current source (82) of the starter circuit (71); and/or
- a solar module (30a) of the string, that has a solar junction box without the safety circuit (13) so that this solar module (30a) is not set into a safe state (111).

15. The method according to any one of claims 12 to 14, wherein for connecting the solar junction boxes (12) to the string (20), one or more of the following steps are performed in the starter circuit (71):
- opening the isolating switch (54) of the start box (70) to disconnect the inverter (90);
- closing the first switch (53) of the start box (70) to close the electrical circuit of the string (20) through the starter circuit (71) and injecting the starting current into the string line (18);
- measuring the string voltage (U3) in the start box (70);
- when the string voltage (U3) exceeds a predefined threshold value, disconnecting the current source (82) from the string (20) to stop the injecting of the starting current into the string (20);
- closing the isolating switch (54) to connect the inverter (90) to the string.

## Revendications

1. Installation photovoltaïque (1) comprenant au moins une chaîne (20) de modules solaires (30) branchés en série, et conçue pour la mise hors tension individuelle des modules solaires (30) et pour la première connexion sécurisée ou le rebranchement des modules solaires (30), mis hors tension, sur la chaîne, comprenant :
une pluralité de modules solaires (30) qui comportent chacun une boîte de jonction solaire (12), les boîtes de jonction solaire (12) présentant respectivement des éléments de connexion positifs et négatifs (22) côté entrée, qui sont raccordés aux conducteurs sous tension du pôle positif et du pôle négatif du module solaire (30) associé, et respectivement des éléments de connexion positifs et négatifs (62) côté sortie,
sachant que les modules solaires (30) sont reliés en série à la chaîne (20), au moyen d'une ligne de chaîne (18) raccordée aux éléments de connexion positifs et négatifs (62) côté sortie,
sachant qu'au moins une des boîtes de jonction solaire (30) présente un circuit de sécurité (13) qui comprend un interrupteur de court-circuit (52), entre les éléments de connexion positifs et négatifs (62) côté sortie, et un sectionneur (51) branché en série dans la chaîne, et qui définit un état de fonctionnement (117) dans lequel, lorsque le sectionneur (51) est fermé et l'interrupteur de court-circuit (52) est ouvert, le courant solaire produit par le module solaire (30) associé est évacué via la ligne de chaîne (18), par l'intermédiaire de la boîte de jonction solaire (12), et qui définit un état de sécurité (111) dans lequel, lorsque le sectionneur (51) est ouvert et l'interrupteur de court-circuit (52) est fermé, le module solaire (30) associé est mis hors tension par rapport à la ligne de chaîne (18) raccordée, au moyen du circuit de sécurité (13), et la ligne de chaîne reste néanmoins fermée par le biais de l'interrupteur de court-circuit (52) fermé,
un circuit de démarrage (71) qui est raccordé à la ligne de chaîne (18) et est conçu pour appliquer un courant de démarrage au circuit électrique de la ligne de chaîne (18) fermé par le biais de l'interrupteur de court-circuit (52) fermé,
sachant que le circuit de sécurité (13) présente un capteur de courant (68) et est conçu pour commuter automatiquement de l'état de sécurité (111) à l'état de fonctionnement (117), en réponse au courant de démarrage mesuré ou détecté par le capteur de courant et circulant dans le circuit électrique de la ligne de chaîne (18) fermé par l'interrupteur de court-circuit (52).

2. Installation photovoltaïque (1) selon la revendication 1, dans laquelle le circuit de démarrage (71) est logé dans une boîte de démarrage (70) qui est raccordée à la ligne de chaîne (18), séparément des modules solaires (30).

3. Installation photovoltaïque (1) selon une des revendications précédentes, dans laquelle le courant de démarrage comprend un courant constant et/ou une ou plusieurs impulsions de courant qui passent dans la ligne de chaîne (18) fermée au moyen de l'interrupteur de court-circuit (52).

4. Installation photovoltaïque (1) selon une des revendications précédentes, dans laquelle le circuit de sécurité (13) comprend un dispositif de commande (40) qui ferme le sectionneur (51) et/ou ouvre l'interrupteur de court-circuit (52), en réponse au courant de démarrage appliqué à la ligne de chaîne (18).

5. Installation photovoltaïque (1) selon la revendication 4, dans laquelle le dispositif de commande (40), à l'état de sécurité (111), est alimenté en puissance électrique par le module solaire (30) associé, si le module solaire (30) associé reçoit de la lumière, afin que le dispositif de commande (40) puisse commuter le circuit de sécurité (13) de l'état de sécurité (111) à l'état de fonctionnement (117).

6. Installation photovoltaïque (1) selon une des revendications précédentes, dans laquelle le capteur de courant (68), à l'état de sécurité, mesure ou détecte le courant de démarrage appliqué et, à l'état de fonctionnement, mesure le courant solaire injecté dans la chaîne.

7. Installation photovoltaïque (1) selon une des revendications précédentes, dans laquelle le circuit de sécurité (13) est conçu de telle manière qu'en cas d'ombrage du module solaire (30) associé ou en cas d'obscurité générale et de chute de la tension des modules qui en résulte, il commute automatiquement de l'état de fonctionnement (117). à l'état de sécurité (111).

8. Installation photovoltaïque (1) selon une des revendications précédentes, dans laquelle la boîte de jonction solaire (12) présente au moins un des dispositifs suivants :
- un premier capteur de tension (36) qui mesure la tension de module (U1) du module solaire (30) associé,
- un deuxième capteur de tension (66) qui mesure la tension de chaîne (U2),
- un capteur de température (94) qui surveille la température du module solaire (30) associé,
sachant que le dispositif de commande (40) interroge le premier capteur de tension (36) et/ou le deuxième capteur de tension (66) et/ou le capteur de température (94) et, en réaction à cela, active le circuit de sécurité (13).

9. Installation photovoltaïque (1) selon une des revendications précédentes, dans laquelle tous les modules solaires (30) d'une chaîne (20) présentent une boîte de jonction solaire (12) avec le circuit de sécurité (13) qui définit un état de fonctionnement (117), dans lequel le courant solaire produit par le module solaire (30) associé est transmis au réseau électrique via la ligne de chaîne (18), par l'intermédiaire de la boîte de jonction solaire (12), et qui définit un état de sécurité (111) dans lequel le circuit de sécurité met le module solaire (30) associé hors tension par rapport à la ligne de chaîne (18) raccordée.

10. Boîte de démarrage (70) comprenant un circuit de démarrage (71) conçu pour le raccordement à la ligne de chaîne (18) d'une installation photovoltaïque (1) selon une des revendications précédentes, et pour l'application du courant de démarrage au circuit électrique fermé de la ligne de chaîne (18), afin de provoquer la commutation du circuit de sécurité (13) de l'état de sécurité (111) à l'état de fonctionnement (117).

11. Boîte de jonction solaire (12) intelligente, destinée au montage sur un module solaire (30) et au raccordement à la ligne de chaîne (18) d'une installation photovoltaïque (1) selon une des revendications 1 à 9, comprenant :
des éléments de connexion positifs et négatifs (22) côté entrée, destinés au raccordement des conducteurs sous tension respectivement du pôle positif et du pôle négatif du module solaire (30) associé, et des éléments de connexion positifs et négatifs (62) côté sortie, destinés au raccordement de la ligne de chaîne (18),
un circuit de sécurité (13) qui comprend un interrupteur de court-circuit (52), entre les éléments de connexion positifs et négatifs (62) côté sortie, et un sectionneur (51) branché en série dans la ligne, et qui définit un état de fonctionnement (117), dans lequel, lorsque le sectionneur (51) est fermé et l'interrupteur de court-circuit (52) est ouvert, le courant solaire produit par le module solaire (30) associé est évacué via la ligne de chaîne (18), par l'intermédiaire de la boîte de jonction solaire (12), et qui définit un état de sécurité (111) dans lequel, lorsque le sectionneur (51) est ouvert et l'interrupteur de court-circuit (52) est fermé, le module solaire (30) associé est mis hors tension par rapport à la ligne de chaîne (18) raccordée, au moyen du circuit de sécurité (13), et la ligne de chaîne est néanmoins fermée par le biais de l'interrupteur de court-circuit (52) fermé,
sachant que le circuit de sécurité (13) présente un capteur de courant (68) et est conçu pour commuter automatiquement de l'état de sécurité (111) à l'état de fonctionnement (117), en réponse à un courant de démarrage qui est mesuré ou détecté par le capteur de courant et qui circule dans le circuit électrique de la ligne de chaîne (18) fermé par l'interrupteur de court-circuit (52).

12. Procédé de mise en circuit sécurisée d'une chaîne (20) de modules solaires (30) d'une installation photovoltaïque (1) branchés en série, selon lequel les circuits de sécurité (13) définissent un état de sécurité (111), dans lequel les modules solaires (30) sont individuellement mis hors tension par rapport à la ligne de chaîne (18) et la ligne de chaîne (18) est néanmoins fermée en l'absence de défaillance, comprenant les étapes suivantes :
application d'un courant de démarrage au circuit électrique fermé de la ligne de chaîne (18),
mesure ou détection du courant de démarrage circulant dans le circuit électrique fermé de la ligne de chaîne (18), et
connexion automatique des modules solaires (30) à la chaîne (20), au moyen du circuit de sécurité (13) de la boîte de jonction solaire (12) associée, en réponse au résultat de mesure ou de détection du courant de démarrage circulant dans le circuit électrique fermé de la ligne de chaîne (18), de manière à garantir que la ligne de chaîne (18) soit fermée et qu'il ne puisse pas y avoir de tension d'ouverture lorsque la puissance solaire produite est évacuée via la chaîne (20), après la connexion automatique des modules solaires (30).

13. Procédé selon la revendication 12, selon lequel l'application du courant de démarrage est commandée par une boîte de démarrage (70) centrale connectée à la chaîne (20), en réponse :
- à l'actionnement manuel d'un interrupteur d'activation (55) sur la boîte de démarrage (70) et/ou
- au démarrage télécommandé du circuit de démarrage (71) par envoi d'un signal de démarrage à une interface (84) du contrôleur (80) du circuit de démarrage (71) et/ou
- au démarrage automatique en réponse à une synchronisation (79) et/ou
- au démarrage automatique en réponse à l'évaluation d'un capteur de rayonnement (78) raccordé au circuit de démarrage (71) de la boîte de démarrage (70).

14. Procédé selon la revendication 12 ou 13, selon lequel le courant de démarrage appliqué à la ligne de chaîne (18) est fourni :
- par une source de courant (82) distincte sur le circuit de démarrage (71) et/ou
- par un module solaire (30a) de la chaîne, doté d'une boîte de jonction solaire sans circuit de sécurité (13), de sorte que ce module solaire (30a) n'est pas amené à un état de sécurité (111).

15. Procédé selon une des revendications 12 à 14, selon lequel, pour la connexion des boîtes de jonction solaire (12) à la chaîne (20), une ou plusieurs des étapes suivantes sont exécutées dans le circuit de démarrage (71) :
- ouverture du sectionneur (54) de la boîte de démarrage (70) pour mettre l'onduleur (90) hors tension,
- fermeture du premier interrupteur (53) de la boîte de démarrage (70) pour fermer le circuit électrique de la chaîne (20), par l'intermédiaire du circuit de démarrage (71), et application du courant de démarrage à la ligne de chaîne (18),
- mesure de la tension de chaîne (U3) dans la boîte de démarrage (70),
- séparation de la source de courant (82) de la chaîne (20) pour arrêter l'application du courant de démarrage dans la chaîne (20), lorsque la tension de chaîne (U3) dépasse une valeur seuil prédéfinie,
- fermeture du sectionneur (54) pour connecter l'onduleur (90) à la chaîne.
